# EUROPÄISCHE PATENTSCHRIFT

(11) **EP 4 336 577 B1**
(45) Veröffentlichungstag und Bekanntmachung des Hinweises auf die Patenterteilung: **04.03.2026**
(21) Anmeldenummer: 22194794.8
(22) Anmeldetag: 09.09.2022
(51) Int. Cl.: F03G 7/06, H10N 35/80

(54) **AKTUATORANORDNUNG UND VERFAHREN ZUM BETRIEB**
ACTUATOR ARRANGEMENT AND METHOD FOR OPERATING
ENSEMBLE ACTIONNEUR ET PROCÉDÉ DE FONCTIONNEMENT

(43) Veröffentlichungstag der Anmeldung: 13.03.2024
(73) Patentinhaber: Technische Universität Berlin, 10623 Berlin (DE)
(72) Erfinder: Courant, Robert, 13125 Berlin (DE); Maas, Jürgen, 32756 Detmold (DE)
(74) Vertreter: Bittner, Thomas L.

(56) Entgegenhaltungen:
- DE-B4- 102005 038 891
- DE-T2- 69 129 687
- US-A1- 2006 144 472
- US-A1- 2016 087 553
- US-A1- 2021 082 604
- US-B2- 10 581 345

## Beschreibung

Die Erfindung betrifft eine Aktuatoranordnung sowie ein Verfahren zum Betrieb einer Aktuatoranordnung.

### Hintergrund

Magnetische Formgedächtnislegierungen (englisch: magnetic shape memory alloys, MSMA) sind spezielle Formgedächtnislegierungen, die neben dem thermischen Formgedächtniseffekt auch einen magnetischen Formgedächtniseffekt aufweisen. Hierbei geht eine Änderung der magnetischen Orientierung der magnetischen Elementarzellen der Formgedächtnislegierung mit einer Verformung einher, bei der (für eine Raumrichtung betrachtet) eine Längenänderung auftritt.

Die Umorientierung kann durch äußere Kräfte mittels Komprimierung bzw. Elongation hervorgerufen werden. Hierbei weist das Material eine innere Reibung auf, welche das Überwinden einer Kraft- bzw. Spannungsgrenze für die Umorientierung erfordert. Dieses Phänomen ist auch unter der Bezeichnung "Zwillingsspannung" bekannt. Neben dieser Zwillingsspannung zeigen MSMA auch den namensgebenden magnetischen Formgedächtniseffekt. Dabei ruft ein ausreichend großes Magnetfeld eine Kontraktion (Zug) in Feldrichtung hervor und entsprechend senkrecht dazu eine Elongation (Druck), wobei beide Kraftwirkungen genutzt werden können.

Im Gegensatz zu rein thermischen Formgedächtnislegierungen haben MSMA bei gleichem Hub deutlich schnellere Reaktionszeiten (wenige ms gegenüber s). Gegenüber piezoelektrischen Werkstoffen ist ein deutlich höherer Hub erreichbar. Bei einer geeigneten Auswertung kann self-sensing zur Kostenreduktion bei der Sensorik genutzt werden.

Aufgrund der materialinhärenten Zwillingsspannung eignen sich magnetische Formgedächtnislegierungen für Linearaktoren, die eine eingestellte Position ohne Energiezufuhr halten können. Dies ist beispielsweise für Anwendungen mit spezifischen Sicherheitsanforderungen bei Energieausfall interessant. Die Technologie vereint dabei eine große Haltekraft, wie sich auch bei Aktoriken mit selbsthemmendem Getriebe erreichbar ist, mit einer hohen Dynamik, wie sie elektrodynamische Aktoren zeigen. Derartige Charakteristika sind für diverse Stellvorrichtungen in der Automatisierungs- und Fahrzeugtechnik interessant, beispielweise als Greifer in der Robotik, aber auch für Ventile in Pneumatik- und Hydraulik-Systemen.

Bekannte MSMA-Aktoren arbeiten üblicherweise als reine Druck- bzw. Zug-Aktoren gegen eine Rückstellkraft. Diese Rückstellkraft muss die materialinhärenten Zwillingsspannungen überschreiten, damit der Aktor ohne Anregung wieder in die Ursprungslage zurück verformt werden kann. Eine derartige Aktoreinrichtung ist aus dem Dokument DE 10 2005 038 891 A1 bekannt. In einer solchen Konfiguration ist die Zwillingsspannung als reiner Verlust zu betrachten. Um eine Position außerhalb der Ruhelage halten zu können muss dauerhaft ein Magnetfeld aufgebracht werden. Daher werden die Legierungen und die daraus gefertigten Aktoren (üblicherweise in der Form von Sticks) möglichst auf geringe Zwillingsspannungen optimiert.

Im Unterschied dazu nutzen multistabile Konzepte explizit die Zwillingsspannung für eine passive Haltekraft in mehr als einer Position aus. Gemäß einem Konzept wird nur diese Haltekraft genutzt, nicht aber der magnetische Formgedächtniseffekt. Beispielsweise wird die Aktuation durch einen Tauchspulenaktor realisiert und ein MSMA-Element bringt nur eine passive Haltekraft auf. Diese muss dann bei jeder Aktuation zusätzlich überwunden werden.

Ein weiteres Konzept nutzt den magnetischen Formgedächtniseffekt in einer Richtung und sieht eine Rückstellung über das Aufbringen einer mechanischen Kraft vor. Durch die Kombination von zwei derartigen Aktoren kann ein Push-Push-Aktor aufgebaut werden, bei dem zwei MSMA-Aktoren einander gegenüberliegend mit einander entgegengesetzten Aktuationsrichtungen angeordnet werden. Wird das eine MSMA-Element angeregt, wird ein mittiger Abgriff in die Aktuationsrichtung des einen MSMA-Elements verschoben. Wird das andere MSMA-Element angeregt, bewegt sich der Abgriff in die entgegengesetzte Richtung. Hierbei wird jeweils ein MSMA-Element aktiv genutzt, während die Zwillingsspannung des anderen MSMA-Elements passiv durch die von dem aktiven MSMA-Element aufgebrachte Kraft überwunden werden muss. Für einen solchen Aufbau sind für die MSMA-Elemente unabhängige Erregersysteme nötig, von denen immer nur eines im Einsatz ist.

Schließlich existieren Konzepte, welche sowohl die Haltekraft als auch den magnetischen Formgedächtniseffekt in beiden Richtungen nutzen. Hierbei müssen einem MSMA-Element senkrechte Felder eingeprägt werden können, um die Verformung in beide Richtungen zu ermöglichen. Ein solches Konzept vereint die multistabile Haltekraft mit der aktorischen Nutzung des vollen Materials. Die Gestaltung des Erregersystems für solche Aktoren ist aufwändig. Beispielsweise können unabhängige Spulen oder Spulensätze für die Anregungsrichtungen vorgesehen sein, wobei dann zu einem gegebenen Zeitpunkt immer nur ein Spulensatz aktiv genutzt wird.

Aus dem Dokument US 10,581,345 B2 ist ein Konzept für den Betrieb eines MSMA-Aktors mit vier Spulen bekannt. Hierbei bilden die vier Spulen zwei Gruppen von zwei miteinander in Reihe geschalteten Spulen. Die Gruppen sind überkreuzt um das MSMA-Element angeordnet. Flussführungselemente sind so gestaltet, dass durch Überlagerung der erzeugten Magnetfelder bei gleicher Bestromungsrichtung in den beiden Gruppen das MSMA-Element in einer ersten Richtung von einem magnetischen Fluss durchsetzt wird und bei entgegengesetzter Bestromungsrichtung in den beiden Gruppen das MSMA-Element in einer zweiten Richtung von einem magnetischen Fluss durchsetzt wird, wobei die zweite Richtung senkrecht zu der ersten Richtung ist.

Das Dokument US 2021/082604 A1 beschreibt ein Magnetfeld-Betätigungssystem, das einen oder mehrere Permanentmagnete verwenden kann, um einen kontrahierten Bereich innerhalb eines MSM-Elements zu induzieren, während sich das System in einem stromlosen Zustand befindet. Der kontrahierte Bereich kann aus einer vertikalen Komponente eines Magnetfelds resultieren, das mit einem oder mehreren Permanentmagneten verbunden ist. Eine Position des kontrahierten Bereichs kann durch Einschalten eines oder mehrerer Elektromagnete entlang des MSM-Elements verschoben werden. Die Leistung der Elektromagneten kann kontinuierlich variiert werden, um ein gleichmäßiges Schwingen der vertikalen Komponente des Magnetfelds zu bewirken, was dazu führen kann, dass sich der kontrahierte Bereich in einer kontinuierlichen Bewegung von einer Seite zur anderen bewegt.

In dem Dokument US 2016/087553 A1 ist eine Betätigungsvorrichtung offenbart, welche ein magnetisches Formgedächtniselement (MSM-Element) umfasst, das so konfiguriert ist, dass es sich in einem Abschnitt des MSM-Elements lokal zusammenzieht, und zwar als Reaktion auf eine lokale Einwirkung einer magnetischen Feldverteilungskomponente, die im Wesentlichen senkrecht zu einer Längsachse des MSM-Elements verläuft. Die Vorrichtung kann außerdem eine Vielzahl von leitfähigen Spulen umfassen, die seitlich vom MSM-Element versetzt sind. Die Mittelachsen jeder leitenden Spule der Vielzahl von leitenden Spulen können im Wesentlichen parallel zu einer Längsachse des MSM-Elements verlaufen.

Das Dokument DE 691 29 687 T2 betrifft eine Vorrichtung zur Erzeugung eines Magnetfeldes für die Bildgebung mittels magnetischer Resonanz.

### Zusammenfassung

Aufgabe der Erfindung ist es, verbesserte Technologien für Aktuatoranordnungen mit magnetischen Formgedächtnislegierungen anzugeben, die insbesondere eine effizientere und/oder gezieltere Flussführung ermöglichen.

Zur Lösung der Aufgabe sind eine Aktuatoranordnung nach dem unabhängigen Anspruch 1 sowie ein Verfahren zum Betrieb einer Aktuatoranordnung bereitgestellt. Ausgestaltungen sind in abhängigen Ansprüchen in dem beigefügten Satz von Ansprüchen angegeben.

Nach einem Aspekt ist eine Aktuatoranordnung geschaffen, mit einem Aktuatorelement, einer ersten Flusserzeugungseinrichtung zur Erzeugung eines magnetischen Flusses, einer zweiten Flusserzeugungseinrichtung zur Erzeugung eines magnetischen Flusses, einer Ansteuervorrichtung und einem Polschuh-Element. Das Aktuatorelement weist eine magnetische Formgedächtnislegierung auf. Ein Bereich des Aktuatorelements hat eine erste Länge in einer ersten Richtung, wenn der Bereich in der ersten Richtung von einem Magnetfeld durchsetzt wird, und hat eine von der ersten Länge verschiedene zweite Länge in der ersten Richtung, wenn der Bereich in einer zweiten Richtung von einem Magnetfeld durchsetzt wird, welche senkrecht zu der ersten Richtung ist. Die Ansteuervorrichtung ist eingerichtet, die erste Flusserzeugungseinrichtung und/oder die zweite Flusserzeugungseinrichtung gemäß einem ersten Betriebszustand und einem zweiten Betriebszustand anzusteuern, derart, dass in dem ersten Betriebszustand das Aktuatorelement von einem ersten magnetischen Fluss in der ersten Richtung durchsetzt wird, und in dem zweiten Betriebszustand das Aktuatorelement von einem zweiten magnetischen Fluss in der zweiten Richtung durchsetzt wird. Das Polschuh-Element ist eingerichtet, den ersten magnetischen Fluss in der ersten Richtung durch das Aktuatorelement zu leiten oder ist eingerichtet, den zweiten magnetischen Fluss in der zweiten Richtung durch das Aktuatorelement zu leiten. Hierbei ist das Polschuh-Element als magnetisch anisotropes Polschuh-Element bereitgestellt.

Weiterhin ist ein Verfahren zum Betrieb einer Aktuatoranordnung bereitgestellt. Das Verfahren umfasst die Schritte des Bereitstellens der offenbarungsgemäßen Aktuatoranordnung, das Ansteuern der ersten Flusserzeugungseinrichtung und/oder der zweiten Flusserzeugungseinrichtung zum Erzeugen des das Aktuatorelement in der ersten Richtung durchsetzenden ersten magnetischen Flusses, derart, dass das Aktuatorelement eine erste Form annimmt, und das Ansteuern der ersten Flusserzeugungseinrichtung und/oder der zweiten Flusserzeugungseinrichtung zum Erzeugen des das Aktuatorelement in der zweiten Richtung durchsetzenden zweiten magnetischen Flusses, derart, dass das Aktuatorelement eine zweite Form annimmt, die von der ersten Form verschieden ist.

Ein magnetisch anisotropes Polschuh-Element im Sinne der Offenbarung weist in einer Richtung einen höheren magnetischen Widerstand auf als in einer anderen Richtung. Insbesondere ist ein Polschuh-Element ein magnetisch anisotropes Polschuh-Element, wenn die (geometrieunabhängige) homogenisierte Anfangspermeabilität des Polschuh-Elements in der einen Richtung wenigstens um den Faktor 250 größer ist als in der anderen Richtung, wobei die homogenisierte Anfangspermeabilität die mittlere relative Permeabilität (oder Permeabilitätszahl) des Polschuh-Elements in der betreffenden Richtung bei kleinen Flussdichten ist, also ohne Sättigung. Wie nachfolgend im Einzelnen ausgeführt, kann das Polschuh-Element mit einem Laminat gebildet sein, wobei in diesem Fall die homogenisierte Anfangspermeabilität des Polschuh-Elements in der betreffenden Richtung für eine Reihen- bzw. Parallelschaltung der Einzelmaterialen bestimmt ist. Durch den Einsatz eines magnetisch anisotropen Polschuh-Elements kann ein magnetischer Fluss durch das Polschuh-Element in einer unerwünschten Richtung verringert oder verhindert sein. Insbesondere kann ein magnetisch anisotropes Polschuh-Element, welches eingerichtet ist, den ersten magnetischen Fluss in der ersten Richtung durch das Aktuatorelement zu leiten, in der ersten Richtung einen kleineren magnetischen Widerstand als in der zweiten Richtung aufweisen. Entsprechend kann ein magnetisch anisotropes Polschuh-Element, welches eingerichtet ist, den zweiten magnetischen Fluss in der zweiten Richtung durch das Aktuatorelement zu leiten, in der zweiten Richtung einen kleineren magnetischen Widerstand als in der ersten Richtung aufweisen. Hierbei kann dann ein das Aktuatorelement umgehender magnetischer Fluss durch das Polschuh-Element in der Richtung des größeren magnetischen Widerstands des Polschuh-Elements verringert oder verhindert sein.

Das Polschuh-Element kann mit einem Laminat gebildet sein, welches aus einer Anordnung von mehreren Schichten besteht, wobei die mehreren Schichten erste Schichten aus einem ersten Material und zweite Schichten aus einem zweiten Material umfassen. Hierbei sind in der Anordnung von mehreren Schichten erste Schichten und zweite Schichten abwechselnd übereinander angeordnet, wobei das erste Material eine erste Permeabilitätszahl (auch als relative Permeabilität bezeichnet) aufweist und das zweite Material eine zweite Permeabilitätszahl aufweist, welche von der ersten Permeabilitätszahl verschieden ist. Hierdurch kann insbesondere erreicht sein, dass das Polschuh-Element in der Erstreckungsrichtung der Schichten einen kleineren magnetischen Widerstand aufweist, als quer zu der Erstreckungsrichtung der Schichten, da sich der magnetische Fluss in Erstreckungsrichtung der Schichten ungehindert durch die Schichten mit der höheren Permeabilitätszahl fortpflanzen kann, während der magnetische Fluss quer zu der Erstreckungsrichtung die Schichten mit der niedrigeren Permeabilitätszahl durchsetzen muss. Bei dem Material des ersten und des zweiten Materials mit der niedrigeren Permeabilitätszahl kann es sich um ein nichtmagnetisches Material handeln. Beispielsweise kann das Polschuh-Element mit einem Laminat aus Weicheisen- und Epoxidharz-Schichten gebildet sein.

In dem Laminat können die Schichten miteinander verbunden sein, wie dies aus dem Stand der Technik in verschiedenen Ausführungen für Laminate als solches bekannt ist, beispielsweise durch eine Klebeverbindung oder thermische Verbindungstechniken.

In einer alternativen Ausgestaltung können in dem Laminat die Schichten mit der niedrigeren Permeabilitätszahl durch Luft, ein anderes Gas oder Gasgemisch, oder durch ein Vakuum gebildet sein. In diesem Fall sind die Schichten nicht miteinander verbunden und das Laminat des Polschuh-Elements kann insbesondere aus einem Material mit hoher Permeabilitätszahl bereitgestellt sein, welches mit Schlitzen und/oder anderen Aussparungen gebildet ist.

Das Polschuh-Element kann mit einem magnetisch anisotropen Material gebildet sein. Hierbei umfasst das Polschuh-Element wenigstens ein Material, welches intrinsisch magnetisch anisotrop ist, also in einer Richtung eine andere magnetische Permeabilität aufweist als in einer anderen Richtung. Die magnetische Anisotropie des Polschuh-Elements kann allein oder wesentlich durch die Verwendung eines magnetisch anisotropen Materials erreicht sein, insbesondere wenn das verwendete Material eine stark ausgeprägt magnetische Anisotropie aufweist. Hierbei ist eine stark ausgeprägte magnetische Anisotropie eines Materials insbesondere gegeben, wenn eine Permeabilitätszahl des Materials in einer Richtung wenigstens um den Faktor 20 größer ist als in der anderen Richtung. Hierbei kann ein magnetisch anisotropes Polschuh-Element mit einer um wenigstens den Faktor 250 größeren homogenisierten Anfangspermeabilität in der einen Richtung als in der anderen Richtung durch einen entsprechend großen Faktor zwischen den richtungsabhängigen Permeabilitätszahlen des magnetisch anisotropen Materials erreicht sein oder kann alternativ durch zusätzliche Maßnahmen erreicht sein, beispielsweise durch eine geeignete Geometrie des Polschuh-Elements und/oder dadurch, dass das Polschuh-Element mit einem Laminat gebildet ist. Insbesondere kann bei einer Ausbildung des Polschuh-Elements mit einem Laminat das erste Material und/oder das zweite Material ein magnetisch anisotropes Material sein. Auf diese Weise kann eine intrinsische magnetische Anisotropie des ersten und/oder des zweiten Materials durch die Anordnung aus mehreren Schichten in dem Laminat für das Polschuh-Element in seiner Gesamtheit verstärkt sein.

Es ist ein dem Polschuh-Element zugeordnetes Flussführungselement vorgesehen, welches mit einer Keilform gebildet ist. Hierbei ist das Flussführungselement derart angeordnet, dass ein magnetischer Widerstand der Anordnung aus Polschuh-Element und zugeordnetem Flussführungselement in der Richtung niedrigeren magnetischen Widerstands des Polschuh-Elements in Randbereichen der Anordnung aus Polschuh-Element und zugeordnetem Flussführungselement höher ist als in einem Mitten-Bereich der Anordnung aus Polschuh-Element und zugeordnetem Flussführungselement. Die Randbereiche sind hierbei Bereiche, die entlang der Richtung höheren magnetischen Widerstands des Polschuh-Elements gegenüberliegend an Rändern des Polschuh-Elements gebildet sind. Der Mitten-Bereich liegt entlang der Richtung höheren magnetischen Widerstands des Polschuh-Elements zwischen den Randbereichen. Die Keilform des Flussführungselements kann so ausgebildet und das Flussführungselement kann so angeordnet sein, dass in den Randbereichen ein größerer Luftspalt zwischen dem Polschuh-Element und dem Flussführungselement gebildet ist als in dem Mitten-Bereich, wobei das Flussführungselement in dem Mitten-Bereich mit einem Luftspalt zu dem Polschuh-Element oder direkt an dem Polschuh-Element anliegend beziehungsweise mit diesem verbunden angeordnet sein kann.

Die Aktuatoranordnung kann mit zwei Polschuh-Elementen gebildet sein, welche entlang der ersten Richtung auf gegenüberliegenden Seiten des Aktuatorelements angeordnet und jeweils eingerichtet sind, den ersten magnetischen Fluss in der ersten Richtung durch das Aktuatorelement zu leiten, wobei die zwei Polschuh-Elemente als magnetisch anisotrope Polschuh-Elemente bereitgestellt sind. Hierzu können die zwei Polschuh-Elemente insbesondere derart angeordnet sein, dass sie in der der ersten Richtung einen kleineren magnetischen Widerstand aufweisen als in der zweiten Richtung. Auf diese Weise kann mittels der zwei Polschuh-Elemente in dem ersten Betriebszustand eine effektive Leitung des magnetischen Flusses in der ersten Richtung durch das Aktuatorelement sichergestellt sein, während in dem zweiten Betriebszustand ein magnetischer Fluss durch die zwei Polschuh-Elemente in der zweiten Richtung unter Umgehung des Aktuatorelements verringert oder unterbunden ist.

Es können zwei weitere Polschuh-Elemente vorgesehen sein, welche entlang der zweiten Richtung auf gegenüberliegenden Seiten des Aktuatorelements angeordnet und jeweils eingerichtet sind, den zweiten magnetischen Fluss in der zweiten Richtung durch das Aktuatorelement zu leiten. Auf diese Weise kann mittels der zwei weiteren Polschuh-Elemente in dem zweiten Betriebszustand eine effektive Leitung des magnetischen Flusses in der zweiten Richtung durch das Aktuatorelement sichergestellt sein.

Die zwei weiteren Polschuh-Elemente können als magnetisch anisotrope Polschuh-Elemente bereitgestellt sein. Hierbei können die zwei weiteren Polschuh-Elemente insbesondere derart angeordnet sein, dass sie in der der zweiten Richtung einen kleineren magnetischen Widerstand aufweisen als in der ersten Richtung. Auf diese Weise kann dann mittels der zwei weiteren Polschuh-Elemente in dem zweiten Betriebszustand eine effektive Leitung des magnetischen Flusses in der zweiten Richtung durch das Aktuatorelement sichergestellt sein, während in dem ersten Betriebszustand ein magnetischer Fluss durch die zwei weiteren Polschuh-Elemente in der ersten Richtung unter Umgehung des Aktuatorelements verringert oder unterbunden ist.

In alternativen Ausgestaltungen sind die zwei weiteren Polschuh-Elemente nicht als magnetisch anisotrope Polschuh-Elemente bereitgestellt. Dies kann insbesondere vorgesehen sein, wenn aufgrund der Ausgestaltung der Aktuatoranordnung in dem ersten Betriebszustand ein magnetischer Fluss durch die zwei weiteren Polschuh-Elemente in der ersten Richtung unter Umgehung des Aktuatorelements nicht oder nicht in einem Ausmaß zu erwarten ist, welches die Effizienz der Aktuatoranordnung in erheblichem Maße reduziert.

In den verschiedenen Ausführungsformen kann jedem oder allen der magnetisch anisotropen Polschuh-Elemente ein keilförmiges Flussführungselement zugeordnet sein, wobei die obigen Ausführungen zu dem Flussführungselement entsprechend gelten.

Das Aktuatorelement kann als stabförmiges Aktuatorelement gebildet sein, welches entlang einer Längsrichtung, welche in der zweiten Richtung verläuft, eine größere Ausdehnung aufweist als in einer Querrichtung, welche in der ersten Richtung verläuft. Ein stabförmiges Aktuatorelement kann insbesondere ein Aspektverhältnis zwischen der Ausdehnung entlang der Längsrichtung und der Ausdehnung entlang der Querrichtung größer oder gleich 3:1 aufweisen. Insbesondere im Zusammenhang mit einem stabförmigen Aktuatorelement mit Längsrichtung entlang der zweiten Richtung kann eine Anordnung mit zwei Polschuh-Elementen vorgesehen sein, welche entlang der ersten Richtung auf gegenüberliegenden Seiten des Aktuatorelements angeordnet und jeweils eingerichtet sind, den ersten magnetischen Fluss in der ersten Richtung durch das Aktuatorelement zu leiten, wobei die zwei Polschuh-Elemente als magnetisch anisotrope Polschuh-Elemente bereitgestellt sind und derart angeordnet sind, dass sie in der der ersten Richtung einen kleineren magnetischen Widerstand aufweisen als in der zweiten Richtung. Auf diese Weise kann dann mittels der zwei Polschuh-Elemente in dem ersten Betriebszustand eine effektive Leitung des magnetischen Flusses in der Querrichtung durch das stabförmige Aktuatorelement sichergestellt sein, während in dem zweiten Betriebszustand ein magnetischer Fluss durch die zwei Polschuh-Elemente in der Längsrichtung unter Umgehung des Aktuatorelements verringert oder unterbunden ist. Dies kann insbesondere von Vorteil sein, wenn aufgrund des geringeren Querschnitts des Aktuatorelements in Längsrichtung und der Länge des Aktuatorelements in Längsrichtung eine Tendenz festzustellen ist, dass der magnetische Fluss in dem zweiten Betriebszustand in erheblichem Maße über die zwei Polschuh-Elemente in der zweiten Richtung verläuft und somit der magnetische Fluss in der zweiten Richtung in dem Aktuatorelement verringert ist. In diesem Fall wird der Verlust von in dem Aktuatorelement wirksamem magnetischem Fluss mittels der Polschuh-Elemente mit in der zweiten Richtung (Längsrichtung des Aktuatorelements) erhöhtem magnetischen Widerstand verringert. Während in Ausgestaltungen zusätzlich zwei weitere Polschuh-Elemente gemäß den vorangehenden Ausführungen als magnetisch anisotrope Polschuh-Elemente bereitgestellt sein können, kann in alternativen Ausgestaltungen im Falle eines großen Aspektverhältnisses zwischen Längs- und Querrichtung des Aktuatorelements hierauf verzichtet werden, insbesondere wenn nicht zu erwarten ist, dass der magnetische Fluss in dem ersten Betriebszustand in erheblichem Maße über die zwei weiteren Polschuh-Elemente in der ersten Richtung verläuft und somit der magnetische Fluss in der ersten Richtung in dem Aktuatorelement verringert ist.

Allgemein kann für ein stabförmiges Aktuatorelement ein beliebiger geeigneter Querschnitt vorgesehen sein. Beispielsweise kann ein offenbarungsgemäßes stabförmiges Aktuatorelement einen rechteckigen, zum Beispiel quadratischen, Querschnitt, einen runden, etwa kreisförmigen oder ovalen, Querschnitt oder einen polygonalen, etwa dreieckigen, hexagonalen oder trapezförmigen, Querschnitt aufweisen.

In alternativen Ausgestaltungen kann das Aktuatorelement mit einer anderen Form als einer Stabform gebildet sein. Beispielsweise kann das Aktuatorelement ein würfelförmiges Aktuatorelement sein.

In weiteren alternativen Ausgestaltungen kann für das Aktuatorelement eine beliebige für eine gegebene Anwendung geeignete Form vorgesehen sein. Zum Beispiel kann ein Aktuatorelement als beliebiges Polyeder oder mit einer geschwungenen Form gebildet sein.

Gemäß einer Ausgestaltung kann vorgesehen sein, dass die erste und die zweite Flusserzeugungseinrichtung jeweils mit einem Flusserzeugungselement gebildet sind, die sich überkreuzende und schräg zu der ersten und der zweiten Richtung verlaufende Magnetfelder erzeugen. In diesem Fall führt eine Überlagerung der durch die erste und die zweite Flusserzeugungseinrichtung erzeugten Magnetfelder in dem ersten Betriebszustand zu dem ersten magnetischen Fluss in der ersten Richtung und in dem zweiten Betriebszustand zu dem zweiten magnetischen Fluss in der zweiten Richtung. Insbesondere kann vorgesehen sein, dass die erste oder die zweite Flusserzeugungseinrichtung mit einer Spule als Flusserzeugungselement gebildet ist und sich der erste und der zweite Betriebszustand in der Bestromungsrichtung dieser Spule unterscheiden, wodurch sich die Richtung des erzeugten Magnetfelds umkehrt und die Überlagerung der schräg zu der ersten und der zweiten Richtung verlaufenden Magnetfelder entsprechend den ersten bzw. zweiten magnetischen Fluss gemäß dem ersten bzw. dem zweiten Betriebszustand ergibt.

Die erste Flusserzeugungseinrichtung und die zweite Flusserzeugungseinrichtung können jeweils wenigstens zwei Flusserzeugungselemente aufweisen. Hierbei kann insbesondere vorgesehen sein, dass die Flusserzeugungselemente derart in einer rechteckigen, insbesondere quadratischen Anordnung angeordnet sind, dass sich die Flusserzeugungselemente der ersten Flusserzeugungseinrichtung in der rechteckigen (quadratischen) Anordnung diagonal gegenüberliegen und sich die Flusserzeugungselemente der zweiten Flusserzeugungseinrichtung in der rechteckigen (quadratischen)Anordnung diagonal gegenüberliegen.

Das Aktuatorelement kann bezogen auf die Anordnung der zwei Flusserzeugungselemente der ersten Flusserzeugungseinrichtung und der zwei Flusserzeugungselemente der zweiten Flusserzeugungseinrichtung mittig angeordnet sein. Alternativ kann das Aktuatorelement bezogen auf die Anordnung der Flusserzeugungselemente in wenigstens einer Raumrichtung außermittig angeordnet sein. In diesem Fall kann der mit den Flusserzeugungselementen erzeugte magnetische Fluss mittels des Polschuh-Elements und/oder mittels eines oder mehrerer weiterer Polschuh-Elemente gemäß dem ersten bzw. dem zweiten Betriebszustand zu dem und durch das Aktuatorelement geführt werden. In einer bevorzugten Ausgestaltung kann das Aktuatorelement gegenüber einer durch die in einer rechteckigen (insbesondere quadratischen) Anordnung angeordneten Flusserzeugungselemente aufgespannten Ebene versetzt angeordnet sein. Mit einer solchen Anordnung kann eine besonders raumsparende Aktuatoranordnung geschaffen sein.

Die erste Flusserzeugungseinrichtung und die zweite Flusserzeugungseinrichtung können jeweils mit wenigstens zwei Spulen als Flusserzeugungselementen gebildet sein. Die wenigstens zwei Spulen der ersten Flusserzeugungseinrichtung können in Reihe geschaltet sein und die wenigstens zwei Spulen der zweiten Flusserzeugungseinrichtung können in Reihe geschaltet sein. In einer solchen Ausführung kann dann das Umschalten zwischen dem ersten und dem zweiten Betriebszustand erfolgen, indem mittels der Ansteuervorrichtung die Bestromungsrichtung der Spulen der ersten Flusserzeugungseinrichtung umgekehrt wird, während die Bestromungsrichtung der Spulen der zweiten Flusserzeugungseinrichtung unverändert bleibt, oder umgekehrt. In diesem Fall kann der mit den Flusserzeugungselementen erzeugte magnetische Fluss mittels des Polschuh-Elements und/oder mittels eines oder mehrerer weiterer Polschuh-Elemente gemäß dem ersten bzw. dem zweiten Betriebszustand zu dem und durch das Aktuatorelement geführt werden, wobei die Richtung der Bestromung in den Betriebszuständen zu einer unterschiedlichen Überlagerung der mittels der Spulen erzeugten Felder und somit zu einem magnetischen Fluss in der ersten Richtung durch das Aktuatorelement bzw. zu einem magnetischen Fluss in der zweiten Richtung durch das Aktuatorelement führt. Dies kann insbesondere für eine Ausführung vorgesehen sein, in der die Flusserzeugungselemente derart in einer rechteckigen (quadratischen) Anordnung angeordnet sind, dass sich die Flusserzeugungselemente der ersten Flusserzeugungseinrichtung in der rechteckigen Anordnung diagonal gegenüberliegen und sich die Flusserzeugungselemente der zweiten Flusserzeugungseinrichtung in der rechteckigen Anordnung diagonal gegenüberliegen.

Die erste Flusserzeugungseinrichtung kann mit wenigstens zwei Spulen als Flusserzeugungselementen gebildet sein, während die zweite Flusserzeugungseinrichtung mit wenigstens zwei Permanentmagneten als Flusserzeugungselementen gebildet ist. In einer solchen Ausführung ist insbesondere vorgesehen, dass mit der zweiten Flusserzeugungseinrichtung mittels der wenigstens zwei Permanentmagnete ein magnetischer Fluss mit konstanter Ausrichtung bereitgestellt wird, und das Umschalten zwischen dem ersten und dem zweiten Betriebszustand kann erfolgen, indem mittels der Ansteuervorrichtung die Bestromungsrichtung der Spulen der ersten Flusserzeugungseinrichtung umgekehrt wird. In diesem Fall kann der mit den Flusserzeugungselementen erzeugte magnetische Fluss mittels des Polschuh-Elements und/oder mittels eines oder mehrerer weiterer Polschuh-Elemente gemäß dem ersten bzw. dem zweiten Betriebszustand zu dem und durch das Aktuatorelement geführt werden, wobei die Richtung der Bestromung der Spulen der ersten Flusserzeugungseinrichtung in den Betriebszuständen zu einer unterschiedlichen Überlagerung der mittels der Spulen erzeugten Felder und somit zu einem magnetischen Fluss in der ersten Richtung durch das Aktuatorelement bzw. zu einem magnetischen Fluss in der zweiten Richtung durch das Aktuatorelement führt. Dies kann insbesondere für eine Ausführung vorgesehen sein, in der die Flusserzeugungselemente derart in einer rechteckigen (insbesondere quadratischen) Anordnung angeordnet sind, dass sich die Flusserzeugungselemente der ersten Flusserzeugungseinrichtung in der rechteckigen Anordnung diagonal gegenüberliegen und sich die Flusserzeugungselemente der zweiten Flusserzeugungseinrichtung in der rechteckigen Anordnung diagonal gegenüberliegen.

In einer alternativen Ausgestaltung können die erste Flusserzeugungseinrichtung und die zweite Flusserzeugungseinrichtung jeweils ein Flusserzeugungselement aufweisen, welches mit einer Spule gebildet ist, wobei die erste Flusserzeugungseinrichtung eingerichtet ist, den ersten magnetischen Fluss zu erzeugen und die zweite Flusserzeugungseinrichtung eingerichtet ist, den zweiten magnetischen Fluss zu erzeugen. Somit können unabhängige Spulen bereitgestellt sein, wobei der mittels einer der Flusserzeugungseinrichtungen erzeugte magnetische Fluss direkt der Herstellung des ersten respektive des zweiten Betriebszustands dient. In diesem Fall kann insbesondere vorgesehen sein, dass die Ansteuervorrichtung die erste Flusserzeugungseinrichtung aktiviert und die zweite Flusserzeugungseinrichtung deaktiviert, um den ersten Betriebszustand einzustellen und die erste Flusserzeugungseinrichtung deaktiviert und die zweite Flusserzeugungseinrichtung aktiviert, um den zweiten Betriebszustand einzustellen, oder umgekehrt. In einer solchen Ausführung kann das Einstellen des ersten und zweiten Betriebszustandes insbesondere erfolgen, ohne dass dies auf einer Überlagerung der mittels der ersten und der zweiten Flusserzeugungseinrichtung erzeugten magnetischen Flüsse basiert.

In einer weiteren alternativen Ausgestaltung kann die erste Flusserzeugungseinrichtung mit einer Spule als Flusserzeugungselement gebildet sein, während die zweite Flusserzeugungseinrichtung mit einem Permanentmagnet als Flusserzeugungselement gebildet ist, wobei die erste Flusserzeugungseinrichtung eingerichtet ist, den ersten magnetischen Fluss zu erzeugen und die zweite Flusserzeugungseinrichtung eingerichtet ist, den zweiten magnetischen Fluss zu erzeugen. In einer solchen Ausführung nimmt die Aktuatoranordnung im Ruhezustand, also ohne Bestromung der Spule der ersten Flusserzeugungseinrichtung, durch die Wirkung des Permanentmagnets der zweiten Flusserzeugungseinrichtung den zweiten Betriebszustand ein. Zum Erzeugen des ersten Betriebszustands erfolgt einen Bestromung der Spule der ersten Flusserzeugungseinrichtung, wobei der erzeugte mittels der Spule magnetische Fluss so groß ist, dass er in dem Aktuatorelement den von dem Permanentmagnet der zweiten Flusserzeugungseinrichtung erzeugten Fluss so überlagert, dass sich in dem Aktuatorelement der erste magnetische Fluss einstellt. In diesem Zusammenhang versteht sich, dass sich mittels einer solchen Überlagerung bereits rechnerisch keine Drehung des resultierenden magnetischen Flusses in dem Aktuatorelement um exakt 90 Grad erreichen lässt. Insofern sind offenbarungsgemäß unter einem ersten magnetischen Fluss, der das Aktuatorelement in der ersten Richtung durchsetzt, und einem zweiten magnetischen Fluss, der das Aktuatorelement in der zweiten Richtung durchsetzt, Flüsse zu verstehen, deren Richtung der ersten bzw. der zweiten Richtung nahe genug kommt, um das Einnehmen der ersten bzw. der zweiten Länge durch den Bereich des Aktuatorelements zu erreichen. Somit ist eine Vorspannung der Aktuatoranordnung hin zu dem zweiten Betriebszustand erreicht.

Alternativ kann die zweite Flusserzeugungseinrichtung mit einer Spule als Flusserzeugungselement gebildet sein, während die erste Flusserzeugungseinrichtung mit einem Permanentmagnet als Flusserzeugungselement gebildet ist, wobei die erste Flusserzeugungseinrichtung eingerichtet ist, den ersten magnetischen Fluss zu erzeugen und die zweite Flusserzeugungseinrichtung eingerichtet ist, den zweiten magnetischen Fluss zu erzeugen. Hierbei gelten die vorigen Ausführungen zu einer mit einer Spule gebildeten ersten Flusserzeugungseinrichtung und einer mit einem Permanentmagnet gebildeten zweiten Flusserzeugungseinrichtung mit den entsprechenden Anpassungen, so dass eine Vorspannung der Aktuatoranordnung hin zu dem ersten Betriebszustand erreicht wird.

Es kann eine der ersten Flusserzeugungseinrichtung oder der zweiten Flusserzeugungseinrichtung zugeordnete Vorspanneinrichtung vorgesehen sein, welche eingerichtet ist, als magnetische Vorspannung einen einem Betrieb der ersten Flusserzeugungseinrichtung, beziehungsweise der zweiten Flusserzeugungseinrichtung, entsprechenden magnetischen Fluss bereitzustellen, wenn die erste Flusserzeugungseinrichtung und die zweite Flusserzeugungseinrichtung nicht in Betrieb sind. In diesem Fall ist die Vorspanneinrichtung zusätzlich zu den Flusserzeugungseinrichtungen bereitgestellt. Beispielsweise kann die Vorspanneinrichtung mit einem oder mehreren Permanentmagneten gebildet sein, die in einem magnetischen Kreis der Aktuatoranordnung derart angeordnet sind, dass sie einen einem Betrieb der ersten Flusserzeugungseinrichtung, beziehungsweise der zweiten Flusserzeugungseinrichtung, entsprechenden magnetischen Fluss bereitstellen.

Eine Richtung der mittels der Vorspanneinrichtung bereitgestellten magnetischen Vorspannung kann mittels der ersten Flusserzeugungseinrichtung und/oder der zweiten Flusserzeugungseinrichtung einstellbar sein. Beispielsweise kann die Vorspanneinrichtung mit einem oder mehreren Elementen aus einem magnetisch halbharten Material gebildet sein, die in einem magnetischen Kreis der Aktuatoranordnung derart angeordnet sind, dass sie bei einem Betrieb der Aktuatoranordnung in dem ersten oder dem zweiten Betriebszustand eine dem betreffenden Betriebszustand entsprechende Magnetisierung annehmen und den betreffenden Betriebszustand aufrechterhalten, wenn die erste Flusserzeugungseinrichtung und die zweite Flusserzeugungseinrichtung nicht in Betrieb sind. Erfolgt anschließend eine Ansteuerung der Aktuatoranordnung entsprechend dem jeweils anderen Betriebszustand, werden die Elementen aus dem magnetisch halbharten Material umgepolt, so dass sie dann den anderen Betriebszustand aufrechterhalten, wenn die erste Flusserzeugungseinrichtung und die zweite Flusserzeugungseinrichtung nicht in Betrieb sind.

In Ausführungen mit einer Vorspanneinrichtung kann vorgesehen sein, dass die Vorspannung mittels der Flusserzeugungseinrichtung, welcher die Vorspanneinrichtung zugeordnet ist, mittels der Flusserzeugungseinrichtung, welcher die Vorspanneinrichtung nicht zugeordnet ist, oder mittels der beiden Flusserzeugungseinrichtungen überwunden wird, um einen Betriebszustand zu erreichen, der nicht der mittels der Vorspannungseinrichtung erreichten Vorspannung entspricht. Beispielsweise kann die Vorspanneinrichtung einer Spule der betreffenden Flusserzeugungseinrichtung zugeordnet sein und einen einem Betrieb der Spule mit einer bestimmten Bestromungsrichtung entsprechenden magnetischen Fluss bereitstellen. In diesem Fall kann ein Betrieb der betreffenden Spule mit der entgegengesetzten Bestromungsrichtung vorgesehen sein, um die Vorspannung zu überwinden und einen gewünschten Betriebszustand der Aktuatoranordnung zu erreichen.

Es kann eine weitere Vorspanneinrichtung vorgesehen sein, wobei dann die Vorspanneinrichtung der ersten Flusserzeugungseinrichtung zugeordnet ist und die weitere Vorspanneinrichtung der zweiten Flusserzeugungseinrichtung zugeordnet ist. Für die weitere Vorspanneinrichtung können die oben im Zusammenhang mit der Vorspanneinrichtung erläuterten Ausführungen entsprechend vorgesehen sein. Insbesondere in Ausführungen, in denen der erste Betriebszustand und der zweite Betriebszustand durch eine Überlagerung der mittels der ersten Flusserzeugungseinrichtung und der zweiten Flusserzeugungseinrichtung erzeugten magnetischen Flüsse erreicht werden, kann dann mittels der Vorspanneinrichtung und der weiteren Vorspanneinrichtung eine Vorspannung hin zu dem ersten oder dem zweiten Betriebszustand bereitgestellt sein, wobei dann der betreffende andere Betriebszustand durch Ansteuern der ersten und/oder der zweiten Flusserzeugungseinrichtung unter Überwindung der magnetischen Vorspannung eingestellt wird.

Analog zu Ausführungen mit einer Vorspanneinrichtung und einer weiteren Vorspanneinrichtung kann eine der ersten oder der zweiten Flusserzeugungseinrichtung zugeordnete Vorspanneinrichtung vorgesehen sein, wobei die betreffende andere Flusserzeugungseinrichtung selbst eine Vorspannung bereitstellt, beispielsweise indem die betreffende andere Flusserzeugungseinrichtung mit einem oder mehreren Permanentmagneten gebildet ist. In diesem Fall können die oben mit Bezug zu der Vorspanneinrichtung und der weiteren Vorspanneinrichtung erläuterten Ausgestaltungen entsprechend vorgesehen sein.

Allgemein kann für die Aktuatoranordnung vorgesehen sein, dass der mit den Flusserzeugungselementen erzeugte magnetische Fluss mittels des Polschuh-Elements und/oder mittels eines oder mehrerer weiterer Polschuh-Elemente gemäß dem ersten bzw. dem zweiten Betriebszustand zu dem und durch das Aktuatorelement geführt werden. Hierbei können die weiteren Polschuh-Elemente in ihrer Form und sonstigen Ausgestaltung an den Aufbau der Aktuatoranordnung, beispielsweise an die Zahl, Art und Anordnung von Flusserzeugungselementen, angepasst sein. Insbesondere können einzelne oder alle der weiteren Polschuh-Elemente als magnetisch anisotrope Polschuh-Elemente bereitgestellt sein, wie vorangehend für verschiedene Ausführungen beispielhaft erläutert. Mittels des Polschuh-Elements und der weiteren Polschuh-Elemente sind dann ein oder mehrere magnetische Kreise gebildet, die jeweils das Aktuatorelement umfassen, um so den gewünschten magnetischen Fluss in dem Aktuatorelement bereitzustellen.

In den verschiedenen Ausführungen kann die Aktuatoranordnung zusätzlich für einen dritten Betriebszustand eingerichtet sein, in dem das Aktuatorelement von einem dritten magnetischen Fluss in einer dritten Richtung durchsetzt wird, die senkrecht sowohl zu der ersten Richtung als auch zu der zweiten Richtung ist. Beispielsweise kann die Aktuatoranordnung eine dritte Flusserzeugungseinrichtung aufweisen, die eingerichtet ist, den dritten magnetischen Fluss zu erzeugen, oder bei der durch Überlagerung des mittels der dritten Flusserzeugungseinrichtung erzeugten magnetischen Flusses mit dem durch die erste Flusserzeugungseinrichtung erzeugten magnetischen Fluss und/oder mit dem durch die zweite Flusserzeugungseinrichtung erzeugten magnetischen Fluss der dritte magnetische Fluss erzeugt werden kann. Für die dritte Flusserzeugungseinrichtung können die oben im Zusammenhang mit der ersten und/oder der zweiten Flusserzeugungseinrichtung ausgeführten Ausgestaltungen entsprechend vorgesehen sein. Alternativ kann die Aktuatoranordnung ohne eine dritte Flusserzeugungsvorrichtung gebildet sein, wobei sich dann der dritte magnetische Fluss durch eine gezielte Überlagerung des durch die erste Flusserzeugungseinrichtung erzeugten magnetischen Flusses und des durch die zweite Flusserzeugungseinrichtung erzeugten magnetischen Flusses zusätzlich zu dem ersten und dem zweiten magnetischen Fluss erzeugen lässt. Im Zusammenhang mit dem dritten Betriebszustand kann eine entsprechende Anordnung mit dem Polschuh-Element und gegebenenfalls weiteren Polschuh-Elementen bereitgestellt sein, die das Bereitstellen des dritten Betriebszustands erlaubt, wobei in diesem Zusammenhang die obigen Ausführungen zur Ausgestaltung magnetischer Kreise im Zusammenhang mit zwei Betriebszuständen entsprechend gelten können.

Insbesondere im Zusammenhang mit einem dritten Betriebszustand, aber auch in anderen Ausführungen, können das magnetisch anisotrope Polschuh-Element und gegebenenfalls weitere anisotrope Polschuh-Elemente in einer Richtung einen geringeren magnetischen Widerstand auf als in zwei zu der einen Richtung und zueinander senkrechten Richtungen. Beispielsweise können das magnetisch anisotrope Polschuh-Element und gegebenenfalls weitere anisotrope Polschuh-Elemente als eine Anordnung von stabförmigen Elementen mit geringem magnetischen Widerstand gebildet sein, welche matrixartig zueinander angeordnet und durch ein Material mit hohem magnetischen Widerstand, insbesondere ein nichtmagnetisches Material, beispielsweise Epoxidharz oder Luft, getrennt ist.

Es kann ein Aktuator mit der Aktuatoranordnung bereitgestellt sein, insbesondere ein Linearaktuator. Die Aktuatoranordnung kann insbesondere in Anwendungen zum Einsatz kommen, in denen eine Linearbewegung bereitgestellt werde muss und bei denen in einer oder mehreren Positionen (passive) Haltekräfte gewünscht sind. Beispielsweise kann ein die Aktuatoranordnung umfassender Aktuator für die Betätigung eines Ventils, einer Greifvorrichtung, beispielsweise an einem Roboterarm, oder einer Sperrvorrichtung und/oder in Pick-and-Place-Anwendungen zum Einsatz kommen.

Die oben in Zusammenhang mit der Aktuatoranordnung erläuterten Ausgestaltungen können für das Verfahren zum Betrieb einer Aktuatoranordnung entsprechend vorgesehen sein.

Bei einem Betrieb einer offenbarungsgemäßen Aktuatoranordnung kann vorgesehen sein, die erste Flusserzeugungseinrichtung und/oder die zweite Flusserzeugungseinrichtung, beziehungsweise eines oder mehrere von Flusserzeugungselementen der ersten und/oder der zweiten Flusserzeugungseinrichtung derart anzusteuern, dass sich die das Aktuatorelement durchsetzende Flussdichte in dem ersten Betriebszustand und/oder in dem zweiten Betriebszustand ändert und/oder dass sich einer oder mehrere weitere Betriebszustände einstellen, in denen das Aktuatorelement von einem weiteren magnetischen Fluss durchsetzt wird, der in einer zu der ersten Richtung und der zweiten Richtung in einem Winkel angeordneten Richtung verläuft. Zum Beispiel können Flusserzeugungselemente der ersten und/oder der zweiten Flusserzeugungseinrichtung derart angesteuert werden, dass sich ein von diesen erzeugter magnetischer Fluss ändert, beispielsweise durch Variation einer Stromstärke mit der ein als Spule gebildetes Flusserzeugungselement bestromt wird. Alternativ oder zusätzlich kann vorgesehen sein, die erste und die zweite Flusserzeugungseinrichtung gleichzeitig zu betreiben, derart dass sich die magnetischen Flüsse so überlagern, dass sich ein das Aktuatorelement in einer zu der ersten Richtung und der zweiten Richtung in einem Winkel angeordneten Richtung durchsetzender magnetischer Fluss einstellt. Hierbei kann durch koordinierte Änderung der von der ersten und der zweiten Flusserzeugungseinrichtung jeweils erzeugten magnetischer Flüsse eine Überlagerung derart erreicht werden, dass sich die Richtung eines das Aktuatorelement durchsetzenden magnetischen Flusses dreht, insbesondere kontinuierlich oder quasi-kontinuierlich von der ersten zu der zweiten Richtung oder umgekehrt.

### Beschreibung von Ausführungsbeispielen

Im Folgenden werden weitere Ausführungsbeispiele unter Bezugnahme auf Figuren einer Zeichnung näher erläutert. Hierbei zeigen:
- Fig. 1: eine schematische Darstellung eines eine magnetische Formgedächtnislegierung umfassenden Aktuatorelements in zwei Betriebszuständen;
- Fig. 2a: eine schematische Darstellung einer bekannten Aktuatoranordnung in einem ersten Betriebszustand;
- Fig. 2b: eine schematische Darstellung der bekannten Aktuatoranordnung in einem zweiten Betriebszustand;
- Fig. 3: ein magnetisches Ersatzschaltbild einer Aktuatoranordnung;
- Fig. 4a: eine schematische Darstellung einer Aktuatoranordnung in einem ersten Betriebszustand;
- Fig. 4b: eine schematische Darstellung der Aktuatoranordnung in einem zweiten Betriebszustand;
- Fig. 5: eine schematische Darstellung einer weiteren Aktuatoranordnung;
- Fig. 6: eine Vergleichsdarstellung magnetischer Flüsse in Aktuatoranordnungen;
- Fig. 7: eine schematische Darstellung einer alternativen Aktuatoranordnung;
- Fig. 8: schematische Darstellungen von Betriebszuständen einer Aktuatoranordnung mit einer permanentmagnetischen Flusserzeugungseinrichtung;
- Fig. 9: schematische Darstellungen von Betriebszuständen einer Aktuatoranordnung mit einer Vorspanneinrichtung;
- Fig. 10: schematische Darstellungen von Betriebszuständen einer weiteren Aktuatoranordnung mit einer Vorspanneinrichtung;
- Fig. 11: schematische Darstellungen von Betriebszuständen einer Aktuatoranordnung mit einer einstellbaren Vorspanneinrichtung;
- Fig. 12: schematische Darstellungen von alternativen Ausführungen für Aktuatoranordnungen;
- Fig. 13: schematische Darstellungen von weiteren alternativen Ausführungen für Aktuatoranordnungen;
- Fig. 14: eine schematische Darstellung einer zusätzlichen Ausführung einer Aktuatoranordnung;
- Fig. 15a: eine schematische Darstellung einer Aktuatoranordnung mit unabhängigen Spulensätzen;
- Fig. 15b: eine schematische Darstellung einer weiteren Aktuatoranordnung mit unabhängigen Spulensätzen;
- Fig. 16: schematische Darstellungen verschiedener Ausgestaltungen von Spulensätzen für eine Aktuatoranordnung;
- Fig. 17: eine schematische Darstellung eines mit einem Laminat gebildeten Polschuh-Elements; und
- Fig. 18: eine schematische Darstellung eines weiteren mit einem Laminat gebildeten Polschuh-Elements.

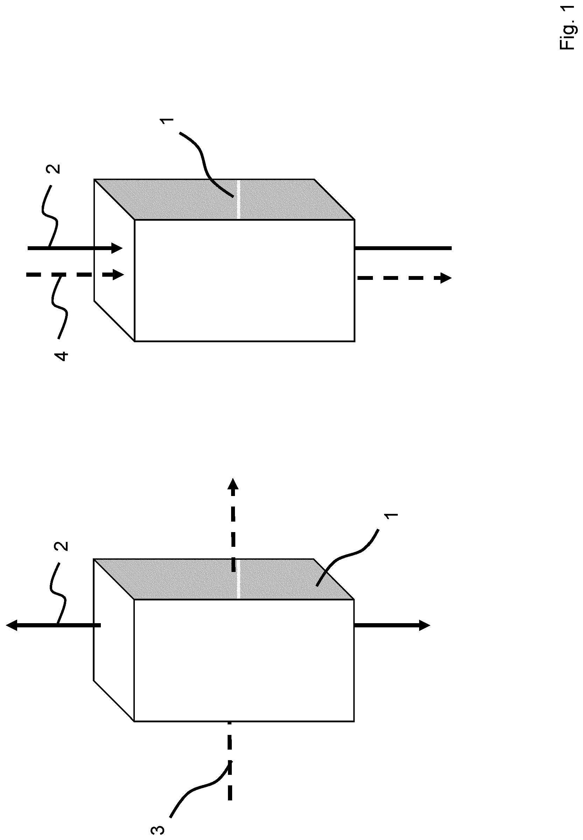

Die Fig. 1 zeigt ein Aktuatorelement 1 aus einer magnetischen Formgedächtnislegierung (MSMA). Das Aktuatorelement 1 ist als stabförmiges Aktuatorelement bereitgestellt und verlängert sich entlang seiner Längsrichtung 2, wenn es von einem (ausreichend großen) ersten magnetischen Fluss 3 durchsetzt wird, der quer zu der Längsrichtung 2 verläuft (Elongation).

Wird das Aktuatorelement 1 von einem zweiten magnetischen Fluss 4 (ausreichender Größe) entlang der Längsrichtung 2 durchsetzt, verkürzt es sich in der Längsrichtung 2 (Kontraktion). Die Formänderung ist durch eine Ausrichtung magnetischer Elementarzellen innerhalb der Formgedächtnislegierung entlang des das Aktuatorelement 1 durchsetzenden Magnetfelds bedingt. Allgemein ruft ein ausreichend großes Magnetfeld in einem MSMA-Element eine Kontraktion (Zug) in Feldrichtung hervor und entsprechend senkrecht dazu eine Elongation (Druck), wobei beide Kraftwirkungen genutzt werden können. Ohne ein das Aktuatorelement 1 durchsetzendes Magnetfeld behält das Aktuatorelement 1 seine Form bei, wobei eine mechanische Verformung des Aktuatorelements ermöglicht ist, wenn eine die sogenannte Zwillingsspannung überwindende äußere Kraft auf das Aktuatorelement 1 einwirkt und so die Ausrichtung der magnetischen Elementarzellen durch mechanische Wirkung verändert.

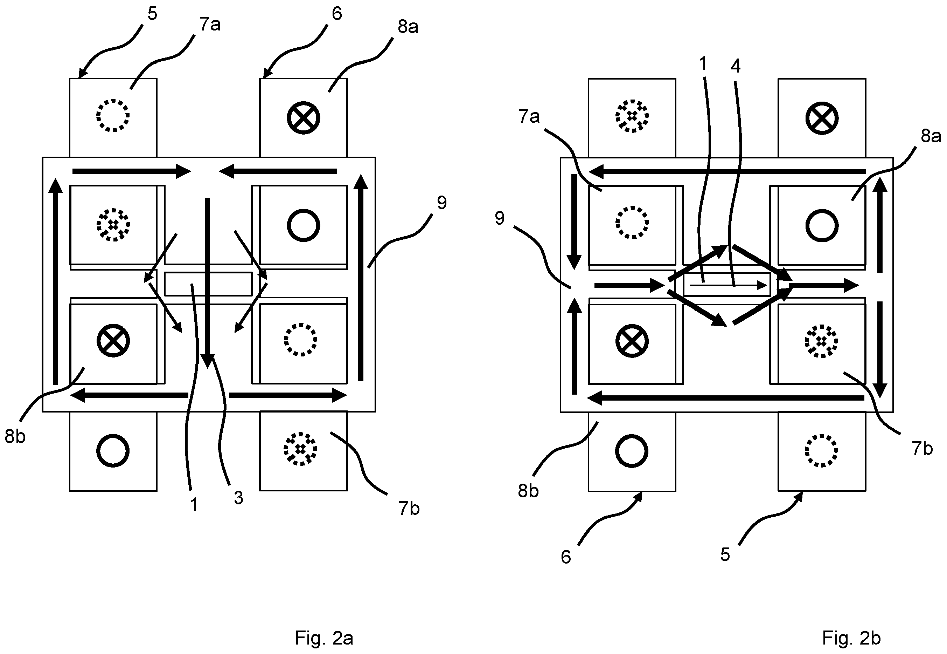

Die Fig. 2a zeigt eine Aktuatoranordnung mit einem MSMA-Aktuatorelement 1, wie sie aus dem Dokument US 10,581,345 B2 bekannt ist. Die Aktuatoranordnung ist mit einer ersten Flusserzeugungseinrichtung 5 und einer zweiten Flusserzeugungseinrichtung 6 gebildet. Die erste Flusserzeugungseinrichtung 5 ist mit zwei Spulen 7a, 7b gebildet und die zweite Flusserzeugungseinrichtung 6 ist mit zwei Spulen 8a, 8b gebildet. Hierbei sind die Spulen 7a, 7b, 8a, 8b in einer rechteckigen, nämlich quadratischen Anordnung ausgerichtet, wobei die Spulen 7a, 7b der ersten Flusserzeugungseinrichtung 5 und die Spulen 8a, 8b der zweiten Flusserzeugungseinrichtung 6 sich jeweils diagonal gegenüberliegen, wie dies in der Fig. 2a erkennbar ist. Die Spulen 7a, 7b der ersten Flusserzeugungseinrichtung 5 sind in Reihe geschaltet und die Spulen 8a, 8b der zweiten Flusserzeugungseinrichtung 6 sind in Reihe geschaltet.

In der Fig. 2a ist ein erster Betriebszustand der Aktuatoranordnung gezeigt, in dem das Aktuatorelement 1 von einem ersten magnetischen Fluss 3 durchsetzt ist. Die Fig. 2b zeigt einen zweiten Betriebszustand, in dem das Aktuatorelement 1 von einem zweiten magnetischen Fluss 4 durchsetzt ist. Die magnetischen Flüsse sind hierbei durch Pfeile veranschaulicht. Die Betriebszustände werden über die Bestromung der Flusserzeugungseinrichtungen 5, 6 erreicht, wobei eine aus Weicheisen gefertigte Jochanordnung 9 den magnetischen Fluss zu dem Aktuatorelement 1 führt. Zum Einstellen des ersten Betriebszustandes werden die Flusserzeugungseinrichtungen 5, 6 bestromt wie durch die Stromrichtungssymbole in der Fig. 2a illustriert. Hierbei ergibt sich für in der Darstellung der Fig. 2a horizontal nebeneinander angeordnete Spulen 7a, 8a / 7b, 8b eine entgegengesetzte Richtung des erzeugten magnetischen Flusses, so dass der magnetische Fluss über die Mitte der Jochanordnung 9 in gemäß der Fig. 2a vertikaler Richtung und somit dem ersten magnetischen Fluss entsprechend durch das Aktuatorelement 1 geführt wird. Für einen Wechsel in den zweiten Betriebszustand wird die Bestromungsrichtung der ersten Flusserzeugungseinrichtung 5 umgekehrt, während die Bestromungsrichtung der zweiten Flusserzeugungseinrichtung 6 unverändert bleibt. Somit ergibt sich für in der Darstellung der Fig. 2b horizontal nebeneinander angeordnete Spulen 7a, 8a / 7b, 8b eine gleiche Richtung des erzeugten magnetischen Flusses, so dass der magnetische Fluss über die Mitte der Jochanordnung 9 in gemäß der Fig. 2b horizontaler Richtung und somit dem zweiten magnetischen Fluss 4 entsprechend durch das Aktuatorelement 1 geführt wird.

In den Darstellungen der Figuren 2a und 2b ist die Stärke des magnetischen Flusses durch die Dicke der Pfeile veranschaulicht. Hierdurch wird erkennbar, dass in dem zweiten Betriebszustand ein erheblicher Teil des magnetischen Flusses an der Aktuatoranordnung 1 vorbei in horizontaler Richtung durch die Jochanordnung 9 verläuft. Es ergibt sich somit ein hoher effektiver Verlust von für eine Verformung des Aktuatorelements 1 zur Verfügung stehendem magnetischen Fluss, so dass die Effizienz der Aktuatoranordnung mit Bezug auf den zweiten Betriebszustand gering ist.

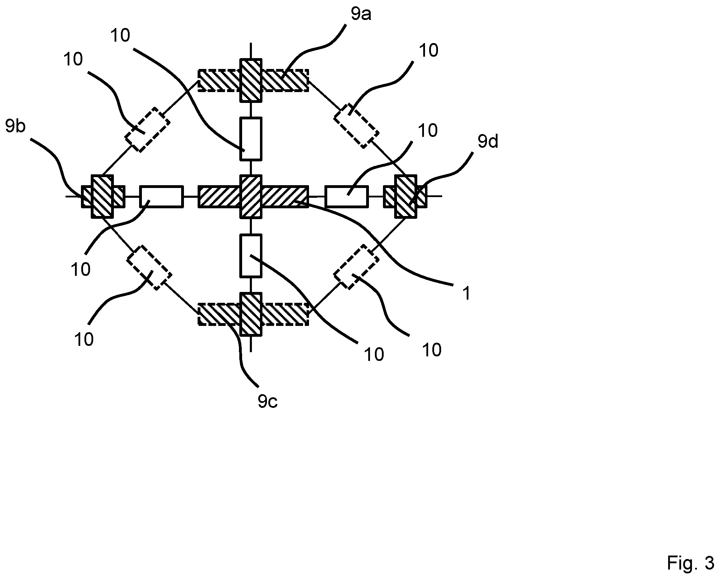

Die Fig. 3 zeigt ein magnetisches Ersatzschaltbild des inneren Bereichs einer Aktuatoranordnung. Der magnetische Fluss in dem Aktuatorelement 1 wird hierbei wesentlich durch die Verhältnisse der magnetischen Widerstände der umliegenden Abschnitte 9a, 9b, 9c, 9d der Jochanordnung 9, des Aktuatorelements 1 sowie der dazwischenliegenden Luftspalte 10 bestimmt.

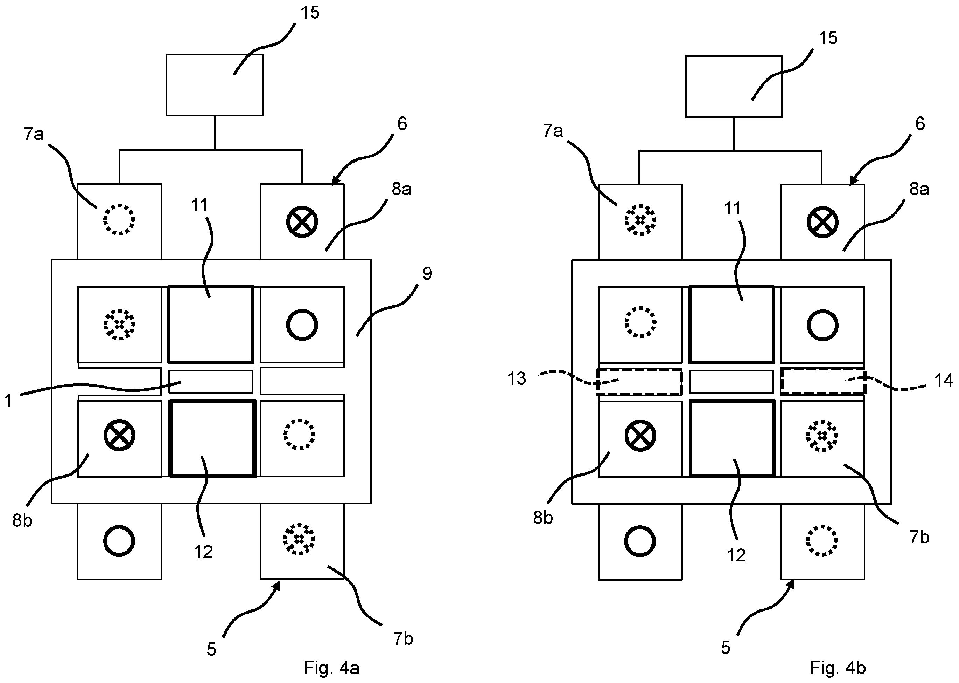

Die Figuren 4a und 4b zeigen eine offenbarungsgemäße Aktuatoranordnung, bei der im Unterschied zu der in den Figuren 2a und 2b gezeigten Anordnung ein magnetisch anisotropes Polschuh-Element 11 vorgesehen ist. Hierbei zeigt die Fig. 4a analog zu der Fig. 2a den ersten Betriebszustand und die Fig. 4b zeigt analog zu der Fig. 2b den zweiten Betriebszustand der Aktuatoranordnung. Das Polschuh-Element 11 ist insofern magnetische anisotrop, dass es entlang der ersten Richtung (in der Darstellung der Figuren 4a und 4b vertikal) einen erheblich niedrigeren magnetischen Widerstand aufweist als entlang der zweiten Richtung (in der Darstellung der Figuren 4a und 4b horizontal). Hierdurch wird in dem ersten Betriebszustand der erste magnetische Fluss effektiv durch das Aktuatorelement 1 geführt. In dem zweiten Betriebszustand wird durch den hohen magnetischen Widerstand des Polschuh-Elements 11 entlang der zweiten Richtung der durch das Polschuh-Element 11 verlaufende Anteil des magnetischen Flusses reduziert, wodurch sich der Anteil des in der zweiten Richtung verlaufenden Flusses durch das Aktuatorelement 1 erhöht, so dass die Effizienz der Aktuatoranordnung in dem zweiten Betriebszustand verbessert ist. Zur Steigerung dieses Effekts ist ein zweites Polschuh-Element 12 dem Polschuh-Element gegenüberliegend angeordnet. Auch das zweite Polschuh-Element 12 ist ein magnetisch anisotropes Polschuh-Element, welches entlang der ersten Richtung einen erheblich niedrigeren magnetischen Widerstand aufweist als entlang der zweiten Richtung.

In der Fig. 4b ist mit gestrichelten Linien eine Weiterentwicklung dargestellt, bei der zusätzlich weitere magnetisch anisotrope Polschuh-Elemente 13, 14 vorgesehen sind, welche entlang der ersten Richtung einen erheblich höheren magnetischen Widerstand aufweisen als entlang der zweiten Richtung und so in dem zweiten Betriebszustand den zweiten magnetischen Fluss effektiv durch das Aktuatorelement 1 führen, während in dem ersten Betriebszustand durch den hohen magnetischen Widerstand der Polschuh-Elemente 13, 14 entlang der ersten Richtung der durch die Polschuh-Elemente 13, 14 verlaufende Anteil des magnetischen Flusses reduziert wird. Zur Führung des magnetischen Flusses kann die Jochanordnung weitere Polschuh-Elemente aufweisen (nicht dargestellt), die jeweils magnetisch anisotrop oder magnetisch isotrop ausgeführt sein können. Ein oder beide weiteren magnetisch anisotropen Polschuh-Elemente 13, 14 können in den nachfolgend erläuterten Ausführungen ebenfalls entsprechend vorgesehen sein.

Die Aktuatoranordnung weist eine Ansteuervorrichtung 15 auf, mit der die Bestromung der Flusserzeugungseinrichtungen 5, 6 zum Einstellen des ersten und des zweiten Betriebszustandes gesteuert wird.

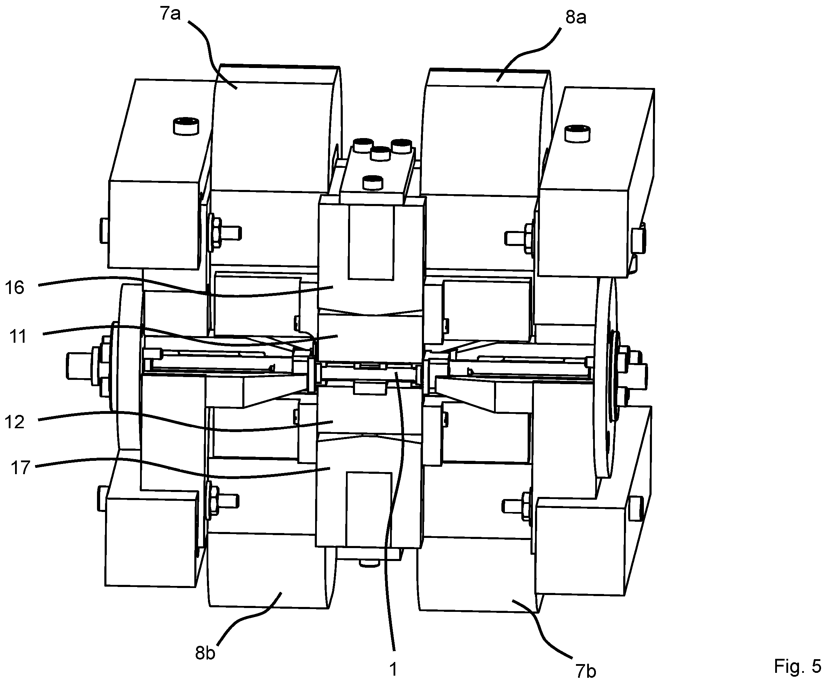

Die Fig. 5 zeigt eine weitere Aktuatoranordnung. Im Vergleich zu der schematischen Darstellung der Figuren 4a und 4b ist in der Fig. 5 ein erfindungsgemäßes Flussführungselement 16 erkennbar, das in der gezeigten Ausführung aus Weicheisen gebildet ist. Das Flussführungselement 16 ist mit einer dem Polschuh-Element 11 zugewandten Keilgeometrie gebildet, so dass das Flussführungselement 14 das Polschuh-Element in einem entlang der zweiten Richtung mittig gelegenen Mitten-Bereich berührt und ein sich entlang der zweiten Richtung zu den Rändern des Flussführungselements 16 vergrößernder Luftspalt gebildet ist. Durch den Luftspalt ist in den Randbereichen der magnetische Widerstand der Anordnung aus Polschuh-Element 11 und Flussführungselement 16 erhöht. Hierdurch ist in dem zweiten Betriebszustand der an dem Aktuatorelement 1 vorbei durch das Polschuh-Element laufende magnetische Fluss weiter verringert. Ein weiteres Flussführungselement 17 mit Keilgeometrie ist dem Polschuh-Element 12 in analoger Anordnung zugeordnet.

In der Aktuatoranordnung gemäß der Fig. 5 liegen die Achsen der Spulen 7a, 7b, 8a, 8b in einer Ebene. Das Aktuatorelement 1 ist zu dieser Ebene versetzt und somit bezüglich der Spulen 7a, 7b, 8a, 8b außermittig, projiziert auf die Ebene jedoch mittig zu den Spulen 7a, 7b, 8a, 8b angeordnet. Hierdurch ist in der dargestellten Anordnung ein besonders kompakter Aufbau erreicht. In alternativen Ausführungen kann das Aktuatorelement auch in der Ebene liegen oder zusätzlich zu der Verrückung aus der Ebene auch in der Projektion auf die Ebene zu den Spulen 7a, 7b, 8a, 8b außermittig verrückt angeordnet sein.

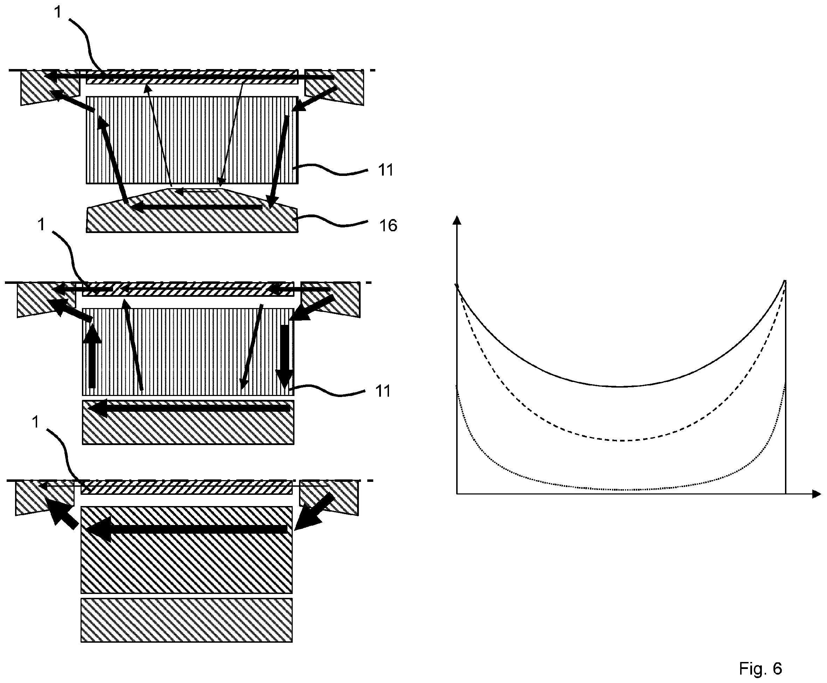

Die Fig. 6 veranschaulicht die durch den Einsatz magnetisch anisotroper Polschuh-Elemente erreichte Effizienzsteigerung. Hierbei sind auf der linken Seite der Fig. 6 übereinander für verschiedene Ausführungen des Mittenbereichs einer Aktuatoranordnung jeweils die Bereiche unterhalb einer Symmetrieachse im zweiten Betriebszustand dargestellt. Unten ist zu Vergleichszwecken eine Anordnung ohne magnetisch anisotropes Polschuh-Element 11 gezeigt. Die mittig gezeigte Anordnung ist mit einem magnetisch anisotropen Polschuh-Element 11 gebildet. Die oben gezeigte Anordnung weist zusätzlich zu einem magnetisch anisotropen Polschuh-Element 11 ein keilförmiges Flussführungselement 16 auf. Der magnetische Fluss ist durch Pfeile dargestellt, wobei ein dickerer Pfeil eine höhere Flussdichte symbolisiert. Wie der Fig. 6 zu entnehmen ist, kann der magnetische Fluss in einer Anordnung ohne magnetisch anisotropes Polschuh-Element 11 somit ungehindert über das magnetisch isotrope Polschuh-Element dem Aktuatorelement 1 ausweichen, so dass der effektive magnetische Fluss in dem Aktuatorelement 1 reduziert ist, wodurch die Effizienz der Aktuatoranordnung in dem zweiten Betriebszustand gering ist. Bei der mittig gezeigten Aktuatoranordnung mit magnetisch anisotropem Polschuh-Element 11 ist ein magnetischer Fluss entlang der zweiten Richtung durch das Polschuh-Element behindert, wodurch die Flussdichte in dem Aktuatorelement 1 erhöht und die Effizienz gesteigert ist. Bei der oben dargestellten Aktuatoranordnung bewirken die durch die Keilgeometrie erreichten Luftspalte zwischen Polschuh-Element 11 und Flussführungselement 16 zusätzlich eine Behinderung eines Flusses entlang der zweiten Richtung durch das Flussführungselement 16, wodurch in der gezeigten Ausführung die Effizienz weiter gesteigert ist.

Dieser Effekt ist in der Fig. 6 anhand mehrerer Graphen nochmals veranschaulicht. Hierbei zeigen die Graphen den Verlauf der magnetischen Flussdichte (Ordinate) in dem Aktuatorelement 1 entlang des Verlaufs des Aktuatorelements 1 in der zweiten Richtung (Abszisse). Es zeigt sich, dass für die in der Fig. 6 links unten dargestellte Aktuatoranordnung gemäß dem gepunktet aufgetragenen Graphen in dem Aktuatorelement 1 nur eine geringe magnetische Flussdichte erreicht wird. Demgegenüber ist für die in der Fig. 6 links mittig dargestellte Aktuatoranordnung mit magnetisch anisotropem Polschuh-Element 11 die magnetische Flussdichte gesteigert (gestrichelt dargestellter Graph). An dem mit durchgezogener Linie dargestellten Graph ist zu erkennen, dass demgegenüber durch den Einsatz eines Flussführungselements 16 mit Keilgeometrie in der links oben dargestellten Aktuatoranordnung eine weitere Steigerung der magnetischen Flussdichte in dem Aktuatorelement 1 erreicht ist, welche darüber hinaus deutlich homogener ist.

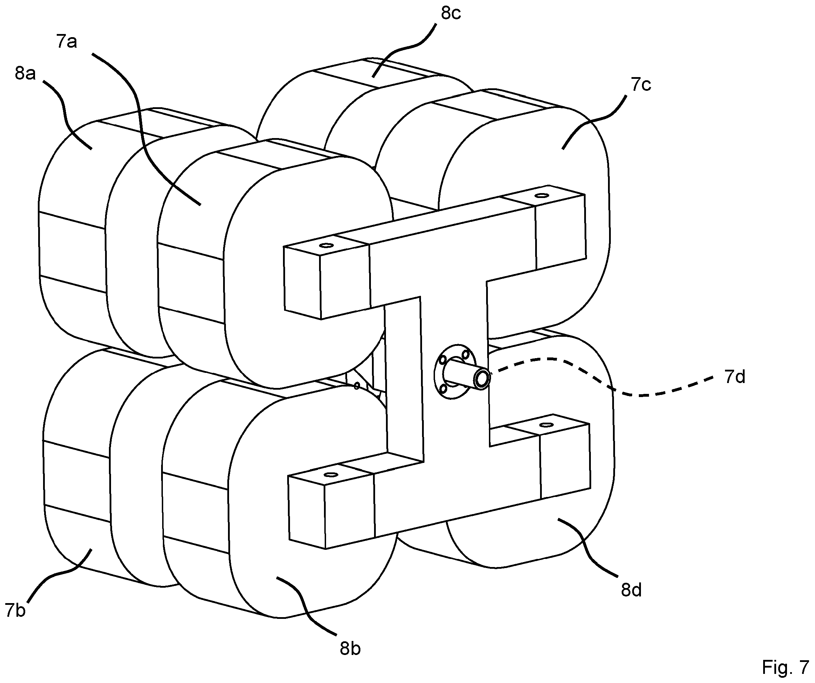

Die Fig. 7 zeigt eine alternative Ausgestaltung einer Aktuatoranordnung. Im Vergleich zu der Aktuatoranordnung der Fig. 5 weist in der Aktuatoranordnung der Fig. 7 die erste Flusserzeugungseinrichtung 5 vier Spulen 7a, 7b, 7c, 7d und die zweite Flusserzeugungseinrichtung 6 vier Spulen 8a, 8b, 8c, 8d auf. Hierbei ist jede der Spulen 7a, 7b, 8a, 8b der Aktuatoranordnung der Fig. 5 gedoppelt. Hiermit kann eine noch höhere Feldstärke erreicht sein. In weiteren Ausführungen kann dieses Konzept auf ein beliebiges Vielfaches von zwei Spulen erweitert werden.

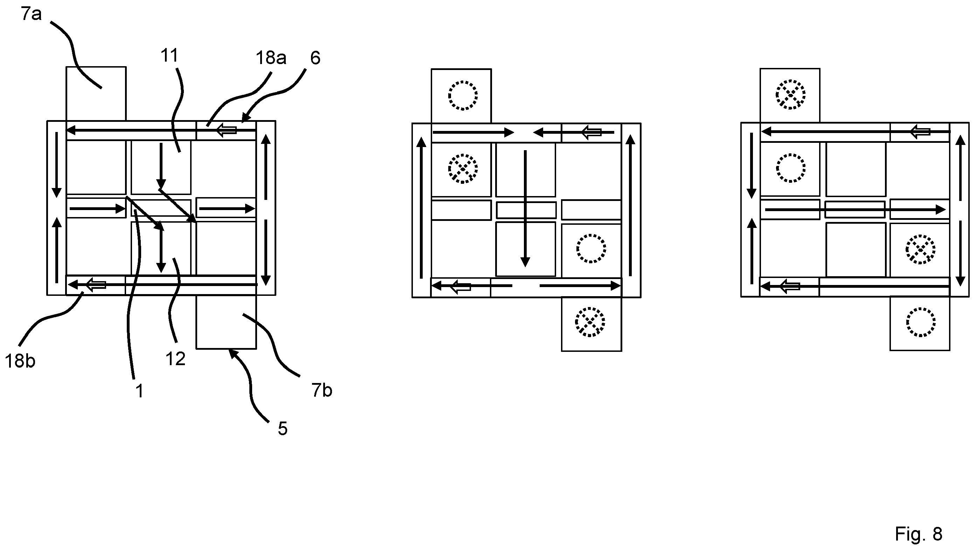

Die Fig. 8 zeigt eine Aktuatoranordnung bei der im Vergleich zu der Aktuatoranordnung der Figuren 4a und 4b die zweite Flusserzeugungseinrichtung 6 statt mit Spulen mit zwei Permanentmagneten 18a, 18b gebildet ist. Hierdurch ergibt sich dauerhaft der gleiche Zustand wie bei der Bestromung der Spulen 8a, 8b der zweiten Flusserzeugungseinrichtung 6 der Aktuatoranordnung der Figuren 4a und 4b. Werden die Spulen 7a, 7b der ersten Flusserzeugungseinrichtung 5 nicht bestromt, ergibt sich somit der in der Fig. 8 links gezeigte keine Bewegung hervorrufende Zustand, in dem sich in dem Aktuatorelement 1 kein dem ersten oder dem zweiten Betriebszustand entsprechender magnetischer Fluss einstellt. Bei Bestromung der Spulen 7a, 7b der ersten Flusserzeugungseinrichtung 5 stellt sich dann entsprechend der Bestromungsrichtung der erste Betriebszustand (Fig. 8 mittig) oder der zweite Betriebszustand (Fig. 8 rechts) ein. Auf diese Weise kann eine besonders energieeffiziente Aktuatoranordnung mit weniger Spulen bereitgestellt sein.

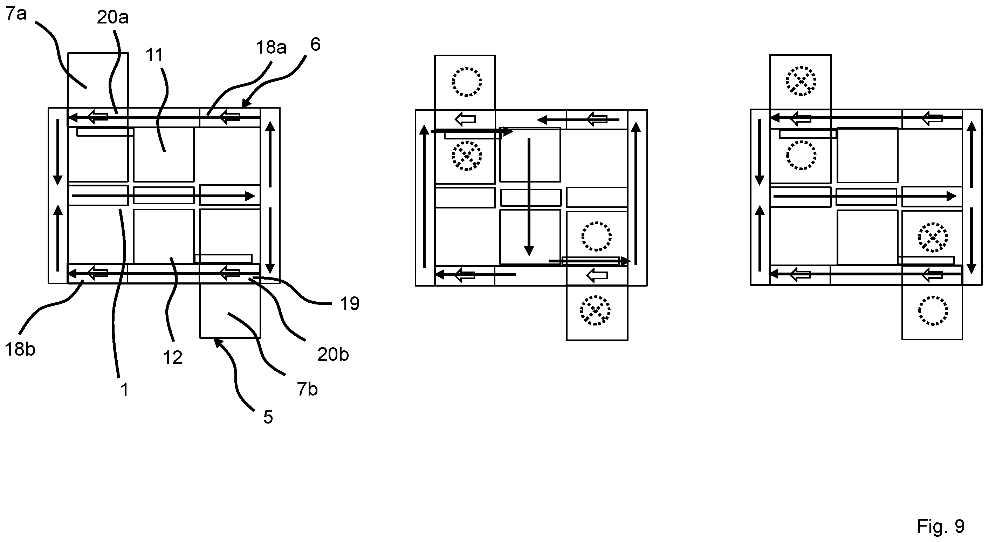

Bei der in der Fig. 9 gezeigten Aktuatoranordnung ist im Vergleich zu der Aktuatoranordnung der Fig. 8 eine der ersten Flusserzeugungseinrichtung 5 zugeordnete Vorspanneinrichtung 19 bereitgestellt, die mit zwei Permanentmagneten 20a, 20b gebildet ist, die im Innern der betreffenden Spulen 7a, 7b der ersten Flusserzeugungseinrichtung 5 angeordnet sind. Durch den mittels der Permanentmagneten 20a, 20b der Vorspanneinrichtung 19 erzeugten magnetischen Fluss ist ohne Bestromung ein der Bestromung der ersten Flusserzeugungsvorrichtung 5 entsprechender Zustand hergestellt. Durch Bestromung der Spulen 7a, 7b der ersten Flusserzeugungsvorrichtung 5 lässt sich dieser Zustand je nach Bestromungsrichtung einer stärkeren Bestromung entsprechend verstärken (Fig. 9 rechts) oder kompensieren (Fig. 9 mittig), so dass der gegenüber dem durch die Vorspanneinrichtung 19 erzeugten Betriebszustand andere Betriebszustand erreicht wird. Im Innern der Spulen 7a, 7b ist parallel zu den Permanentmagneten 20a, 20b jeweils ein mit einem Luftspalt in Reihe angeordneter weichmagnetischer Kern angeordnet. Im Falle einer Kompensation der magnetischen Vorspannung wird der von den Permanentmagneten 20a, 20b erzeugte magnetische Fluss über den jeweiligen Kern und Luftspalt kurzgeschlossen. Im Falle von in Axialrichtung der Spulen 7a, 7b kurzen (schmalen) Permanentmagneten 20a, 20b kann auch ein Kurzschluss ausschließlich über einen parallel zu dem betreffenden Permanentmagneten 20a, 20b angeordneten Luftspalt möglich sein.

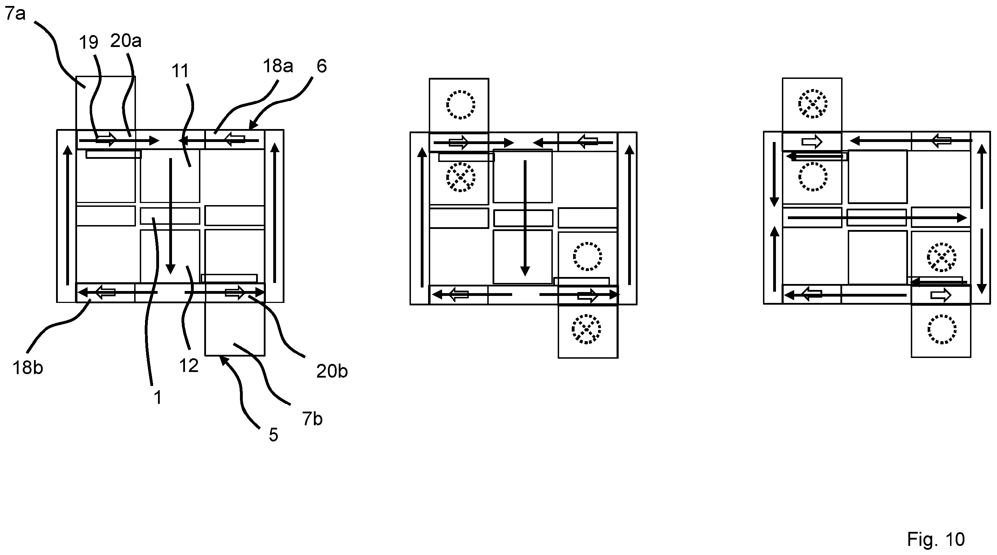

In der Ausführung der Fig. 9 ist die Aktuatoranordnung mittels der Vorspanneinrichtung 19 zu dem zweiten Betriebszustand hin vorgespannt. Im Gegensatz hierzu zeigt die Fig. 10 eine Ausführung, in der die Aktuatoranordnung mittels der Vorspanneinrichtung 19 zu dem ersten Betriebszustand hin vorgespannt ist. Dies ist dadurch erreicht, dass die Magnetisierungsrichtung der Permanentmagnete 20a, 20b gegenüber der Aktuatorvorrichtung der Fig. 9 umgekehrt ist.

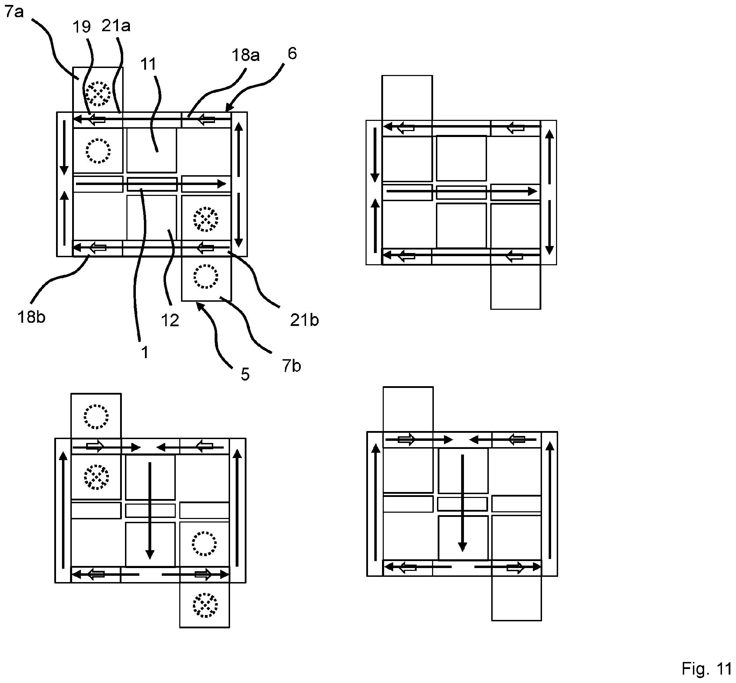

In der Aktuatoranordnung der Fig. 11 ist die Vorspannungseinrichtung 19 mit zwei Vorspann-Elementen 21a, 21b aus magnetisch halbhartem Material gebildet. Magnetisch halbharte Materialien vereinen Eigenschaften von Weicheisen und Permanentmagneten, da sie wie letztere eine hohe Remanenzflussdichte ohne Erregerfeld haben, im Gegensatz dazu aber bereits bei einer geringen Koerzitivfeldstärke ummagnetisiert werden können. Dadurch können sie durch eine kurze Bestromung ausgerichtet werden und dann stromlos den Fluss aufrechterhalten. Somit ergibt sich für die Aktuatoranordnung der Fig. 11, dass der mittels Bestromung der Spulen 7a, 7b der ersten Flusserzeugungseinrichtung 5 eingestellte Betriebszustand auch nach dem Beenden der Bestromung aufrechterhalten wird, da das magnetisch halbharte Material der Vorspann-Elemente 21a, 21b ummagnetisiert wurde. So ist in der Fig. 11 oben links eine Bestromung zum Einstellen des zweiten Betriebszustands gezeigt, der dann nach Ende der Bestromung gemäß der Darstellung in der Fig. 11 oben rechts beibehalten wird. Entsprechend zeigt Fig. 11 unten links eine Bestromung zum Einstellen des ersten Betriebszustands. Dieser wird dann nach Ende der Bestromung gemäß der Darstellung in der Fig. 11 unten rechts beibehalten.

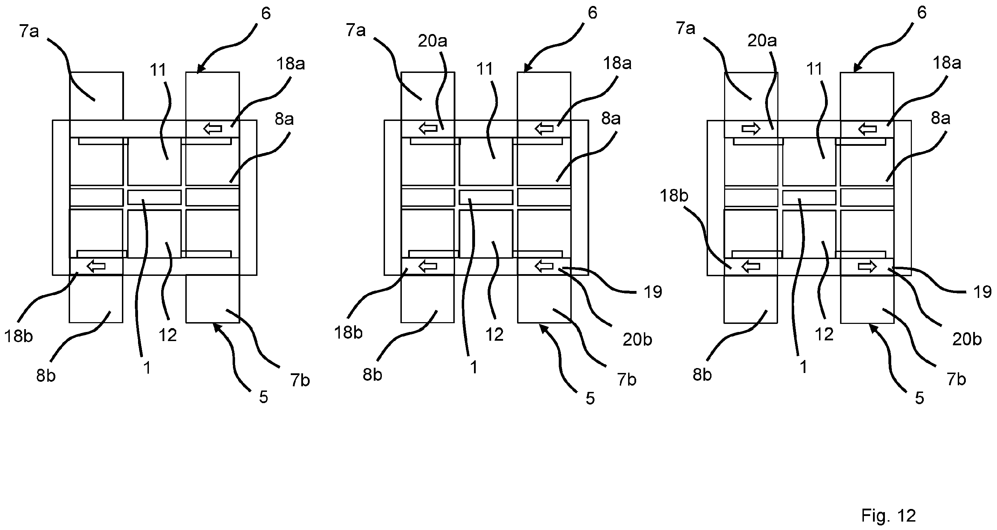

Die Figuren 12, 13 und 14 zeigen alternativen Ausführungen für Aktuatoranordnungen. Das jeweilige grundlegende Konzept ist hierbei symmetrisch. Ein Vertauschen von stationärem (ohne Änderung der Bestromungs- bzw. Magnetfeldrichtung zwischen den Betriebszuständen) und gesteuertem Spulenpaar ändert daher für alle Varianten nichts am Verhalten und ist insofern immer mit gemeint. Ohne Beschränkung der Allgemeinheit werden hier daher einige weitere Aufbaumöglichkeiten mit der bekannten Position des statischen Zweigs gemäß den oben erläuterten Ausführungen dargestellt. In alternativen Ausgestaltungen zu den drei Aktuatoranordnungen der Figuren 8, 9 und 10 kann das statische Paar Permanentmagnete 18a, 18b ohne Spule in allen Fällen ebenfalls durch zusätzlich Spulen 8a, 8b ergänzt werden, die im Verstärkungs- oder Kompensationsmodus (vgl. Ausführungen oben) betrieben werden können. Dadurch ergeben sich die in der Fig. 12 gezeigten Aktuatoranordnungen mit zusätzlichen Ansteuerungskombinationen, wobei die Anordnung in Fig. 12 links eine Weiterentwicklung der Anordnung aus Fig. 8 ist, die Anordnung in Fig. 12 mittig eine Weiterentwicklung der Anordnung aus Fig. 9 ist und die Anordnung in Fig. 12 rechts eine Weiterentwicklung der Anordnung aus Fig. 10 ist.

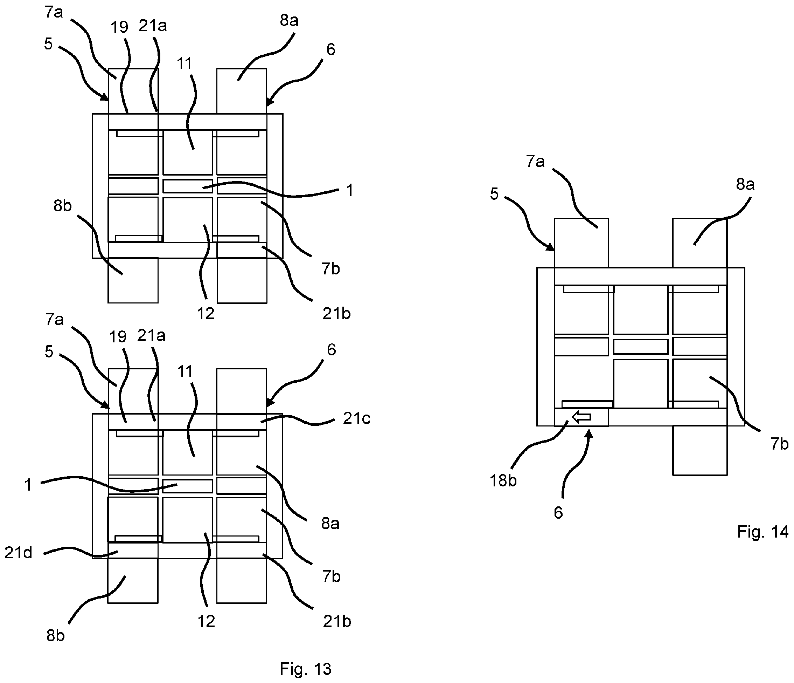

Das statische Paar Permanentmagnete 18a, 18b der Aktuatoranordnung der Fig. 11 kann ebenfalls durch Spulen 8a, 8b ersetzt werden, wie in der Fig. 13 oben gezeigt. Die Fig. 13 zeigt unten eine hiervon ausgehende Weiterentwicklung der Aktuatoranordnung, bei welcher der jeweilige Kern der Spulen 8a, 8b mit magnetisch halbharten Vorspann-Elementen 21c, 21d gebildet ist.

Die Fig. 14 zeigt exemplarisch eine Aktuatoranordnung mit einer Asymmetrie innerhalb der zweiten Flusserzeugungseinrichtung 6, die in dieser Ausführung mit einer Spule 8a und einem Permanentmagnet 18b gebildet ist.

Die in den Figuren 8 bis 14 dargestellten Konzepte lassen sich entsprechend auf von der Darstellung der Figuren 4a und 4b abweichenden Spulenanordnungen übertragen, beispielsweise auf Anordnungen mit außermittig platziertem Aktuatorelement (vgl. Fig. 5), Anordnungen mit mehr als zwei Flusserzeugungselementen je Flusserzeugungseinrichtung (vgl. Fig. 7) oder Anordnungen mit unabhängigen Spulensätzen, wie nachfolgend erläutert.

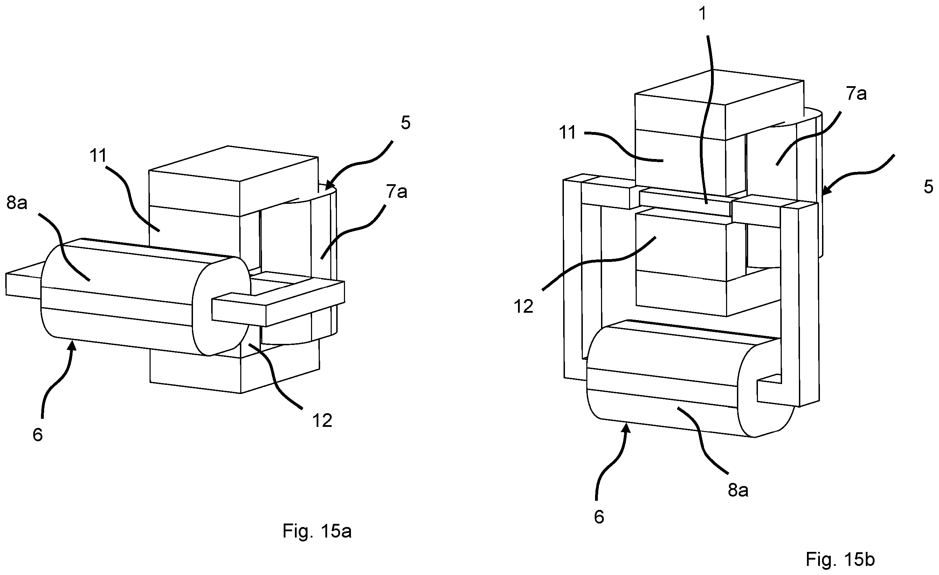

In den Figuren 15a und 15b sind Aktuatoranordnungen gezeigt, bei denen die Flusserzeugungseinrichtungen 5, 6 unabhängige Spulensätze bilden, bei denen also die erste Flusserzeugungseinrichtung 5 den ersten magnetischen Fluss 3 erzeugt und die zweite Flusserzeugungseinrichtung 6 hiervon unabhängig den zweiten magnetischen Fluss 4 erzeugt. Die erste und zweite Flusserzeugungseinrichtungen 5, 6 werden also unabhängig voneinander einzeln aktiviert und eine Überlagerung der erzeugten magnetischen Felder ist nicht vorgesehen, wenn auch weiterhin möglich. Bei den Aktuatoranordnungen der Figuren 15a und 15b ist die erste Flusserzeugungseinrichtung 5 mit einer Spule 7a gebildet und die zweite Flusserzeugungseinrichtung 6 ist mit einer Spule 8a gebildet. Im Vergleich der in den Figuren 15a und 15b gezeigten Anordnungen weist die Aktuatoranordnung der Fig. 15a einen kompakteren Aufbau auf, während die Aktuatoranordnung der Fig. 15b einen leichteren Zugang zum MSMA-Aktuatorelement 1 ermöglicht, wodurch beispielsweise eine vereinfachte Wartung ermöglicht sein kann. Die grundlegende Topologie ist hierbei für beide gezeigten Aktuatoranordnungen identisch. Die genaue Positionierung der Spulen 7a, 8a auf dem jeweiligen Kern ist nur exemplarisch dargestellt und kann beliebig variiert oder auch geteilt werden. Durch einen dritten, unabhängigen Spulensatz kann die Aktuatoranordnung für eine dritte Flussrichtung im Aktuatorelement entsprechend einem dritten Betriebszustand, wie oben dargelegt, erweitert werden.

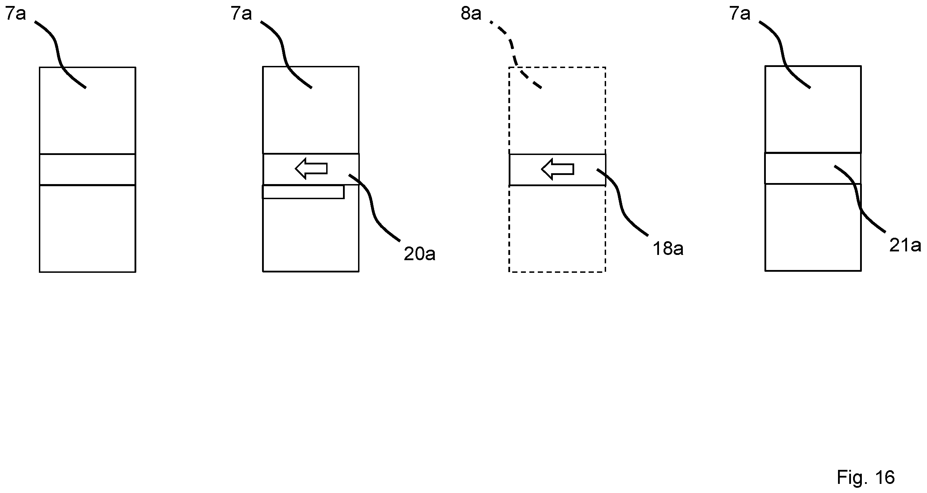

Darüber hinaus ist auch für Aktuatoranordnungen mit als unabhängige Spulensätze gebildeten Flusserzeugungseinrichtungen 5, 6 die Nutzung von Permanentmagneten oder halbharten Materialien zur Effizienzsteigerung möglich, wobei die diesbezüglichen vorangehenden Erläuterungen entsprechend gelten. Da bei dem Konzept der in den Figuren 15a und 15b gezeigten Aktuatoranordnungen eine Spule 7a ausschließlich der Elongation und eine Spule 8a ausschließlich der Kontraktion des Aktuatorelements 1 dient, spielt die jeweilige Bestromungs- und damit Feldrichtung keine Rolle. Für die gewünschte Funktionalität ist nur der Betrag relevant. Jede der beiden Spulen 7a, 8a mit Kern kann durch einen Permanentmagnet 20a ergänzt werden, wie dies in der Fig. 16 in der zweiten Darstellung von links beispielhaft für eine Spule 7a (mit parallelem Luftspalt und Kern) dargestellt ist (ganz links in der Fig. 16 zum Vergleich eine Spule 7a ohne Modifikation). Der Permanentmagnet ermöglicht 20a eine Vorspannung zugunsten der dazugehörigen Bewegung (Kontraktion oder Elongation). Eine Drehung des Magneten 20a um 180 führt zum gleichen Ergebnis. Werden beide Richtungen vorgespannt, ergibt sich wieder ein ausgeglichener Zustand ohne Bewegung. Der komplette Ersatz einer Spule 7a, 8a (in der Fig. 16, zweite Darstellung von rechts beispielhaft die Spule 8a) durch einen Permanentmagneten 18a ist ebenfalls denkbar. Zur Kompensation dieses Effekts ist eine sehr hohe Anregung der anderen Spule erforderlich. Weiterhin kann jede der Spulen 7a, 8a um eine Element 21a aus einer halbharten Legierung ergänzt werden, welche durch die Spulen aktiviert oder kompensiert werden kann. Dies ist für die Spule 7a beispielhaft in der Fig. 16 ganz rechts dargestellt. Somit ergeben sich für jede der Spulen 7a, 8a vier Möglichkeiten zur Modifikation, die entsprechend den jeweiligen Anforderungen einer konkreten Anwendung beliebig miteinander kombiniert werden können.

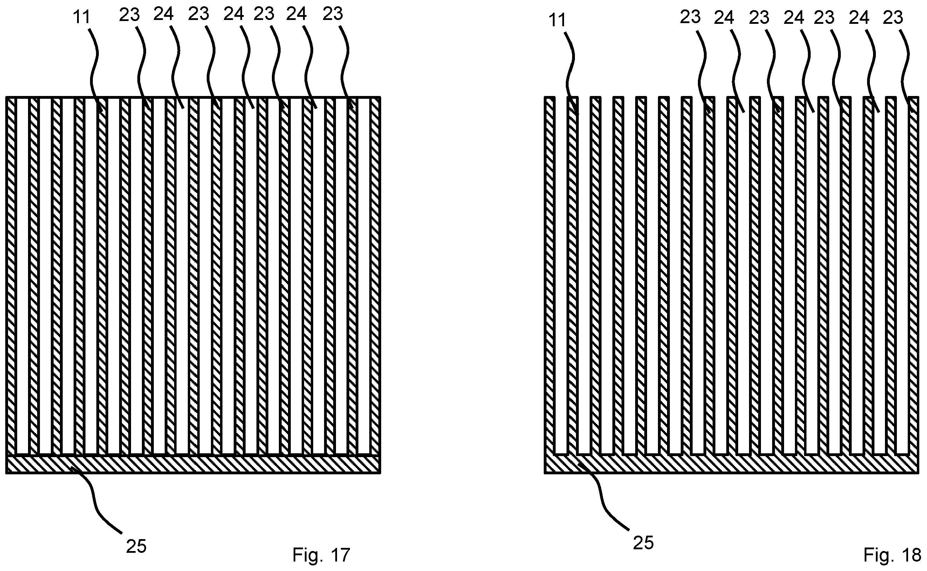

Die Fig. 17 zeigt ein mit einem Laminat 22 gebildetes Polschuh-Element 11. Hierbei besteht das Laminat 22 aus einer Anordnung von mehreren Schichten, in denen abwechselnd erste Schichten 23 aus einem ersten magnetischen Material, beispielsweise Weicheisen, und zweite Schichten 24 aus einem nichtmagnetischen Material, beispielsweise Epoxidharz miteinander verbunden sind. Zum Einkoppeln eines magnetischen Flusses in das Polschuh-Elements 11 weist dieses ein Einkoppelelement 25 aus einem magnetischen Material, beispielsweise dem ersten Material, auf.

Die Fig. 18 zeigt eine alternative Ausgestaltung eines mit einem Laminat 22 gebildetes Polschuh-Elements 11. In der Ausgestaltung der Fig. 18 sind die zweiten Schichten 24 mit Luft gebildet, die Schlitze zwischen den ersten Schichten 23 ausfüllen. Hierbei sind die ersten Schichten mit dem Einkoppelelement 25 einstückig ausgebildet. Alternativ zu Luft können die zweiten Schichten 24 mit einem anderen Gas, einem Gasgemisch oder einer Flüssigkeit gebildet sein, welches nichtmagnetische zweite Schichten 24 zwischen den ersten Schichten 23 bildet.

Bei einer Kombination eines als Laminat 22 bereitgestellten Polschuh-Elements 11, 12, 13, 14 mit einem mit einer Keilform gebildeten Flussführungselement 16, 17 kann durch die Dimensionierung der Keilgeometrie und des anisotropen Laminats die Gewichtung des Feldes längs bzw. quer zum Aktuatorelement 1 je nach Geometrie und gewünschtem Verhalten eingestellt werden. Diese gilt sowohl für den aktiven (Spule als Flusserzeugungselement) als auch den passiven Fall (Permanentmagnet als Flusserzeugungselement) gemäß den vorangehend erläuterten Ausführungen. Darüber hinaus kann durch die Wahl der magnetischen Vorspannung der passive Fall getrennt angepasst werden. Damit kann es kombiniert ermöglicht sein, die Gewichtung im aktiven und passiven Fall bis zu einem gewissen Grad unabhängig voneinander einzustellen. So kann beispielsweise eine passive Vorspannung in der ersten Richtung mit einem Polschuh-Element kombiniert werden, welches eine Bevorzugung der zweiten Richtung darstellt. Auf diese Weise kann es im Kompensationsbetrieb erleichtert sein, aktiv den zweiten Betriebszustand einzustellen, während eine Vorspannung zum ersten Betriebszustand bereitgestellt ist.

Die in der vorstehenden Beschreibung, den Ansprüchen sowie der Zeichnung offenbarten Merkmale können sowohl einzeln als auch in beliebiger Kombination für die Verwirklichung der verschiedenen Ausführungen von Bedeutung sein.

## Patentansprüche

1. Aktuatoranordnung, mit
- einem Aktuatorelement (1), wobei das Aktuatorelement (1) eine magnetische Formgedächtnislegierung aufweist und wobei ein Bereich des Aktuatorelements (1)
- eine erste Länge in einer ersten Richtung hat, wenn der Bereich in der ersten Richtung von einem Magnetfeld durchsetzt wird, und
- eine von der ersten Länge verschiedene zweite Länge in der ersten Richtung hat, wenn der Bereich in einer zweiten Richtung von einem Magnetfeld durchsetzt wird, welche senkrecht zu der ersten Richtung ist;
- einer ersten Flusserzeugungseinrichtung (5) zur Erzeugung eines magnetischen Flusses;
- einer zweiten Flusserzeugungseinrichtung (6) zur Erzeugung eines magnetischen Flusses;
- einer Ansteuervorrichtung (15), welche eingerichtet ist, die erste Flusserzeugungseinrichtung (5) und/oder die zweite Flusserzeugungseinrichtung (6) gemäß einem ersten Betriebszustand und einem zweiten Betriebszustand anzusteuern, derart, dass
- in dem ersten Betriebszustand das Aktuatorelement (1) von einem ersten magnetischen Fluss in der ersten Richtung durchsetzt wird, und
- in dem zweiten Betriebszustand das Aktuatorelement (1) von einem zweiten magnetischen Fluss in der zweiten Richtung durchsetzt wird; und
- einem Polschuh-Element (11, 12, 13, 14), welches eingerichtet ist, den ersten magnetischen Fluss in der ersten Richtung durch das Aktuatorelement (1) zu leiten oder eingerichtet ist, den zweiten magnetischen Fluss in der zweiten Richtung durch das Aktuatorelement (1) zu leiten,
**dadurch gekennzeichnet, dass** das Polschuh-Element (11, 12, 13, 14) als magnetisch anisotropes Polschuh-Element bereitgestellt ist und durch ein dem Polschuh-Element (11, 12, 13, 14) zugeordnetes Flussführungselement (16, 17), welches mit einer Keilform gebildet und derart angeordnet ist, dass ein magnetischer Widerstand der Anordnung aus Polschuh-Element (11, 12, 13, 14) und zugeordnetem Flussführungselement (16, 17) in der Richtung niedrigeren magnetischen Widerstands des Polschuh-Elements (11, 12, 13, 14) in entlang der Richtung höheren magnetischen Widerstands des Polschuh-Elements (11, 12, 13, 14) gegenüberliegenden Randbereichen der Anordnung aus Polschuh-Element (11, 12, 13, 14) und zugeordnetem Flussführungselement (16, 17) höher ist, als in einem Mitten-Bereich der Anordnung aus Polschuh-Element (11, 12, 13, 14) und zugeordnetem Flussführungselement (16, 17).

2. Aktuatoranordnung nach Anspruch 1, wobei
- das Polschuh-Element (11, 12, 13, 14) mit einem Laminat (22) gebildet ist;
- das Laminat (22) aus einer Anordnung von mehreren Schichten besteht;
- die mehreren Schichten erste Schichten (23) aus einem ersten Material und zweite Schichten (24) aus einem zweiten Material umfassen; und
- in der Anordnung von mehreren Schichten erste Schichten (23) und zweite Schichten (24) abwechselnd übereinander angeordnet sind,
wobei das erste Material eine erste Permeabilitätszahl aufweist und das zweite Material eine zweite Permeabilitätszahl aufweist, welche von der ersten Permeabilitätszahl verschieden ist.

3. Aktuatoranordnung nach Anspruch 1 oder 2, wobei das Polschuh-Element (11, 12, 13, 14) mit einem magnetisch anisotropen Material gebildet ist.

4. Aktuatoranordnung nach mindestens einem der vorangehenden Ansprüche mit zwei Polschuh-Elementen (11, 12), welche entlang der ersten Richtung auf gegenüberliegenden Seiten des Aktuatorelements (1) angeordnet und jeweils eingerichtet sind, den ersten magnetischen Fluss in der ersten Richtung durch das Aktuatorelement (1) zu leiten, wobei die zwei Polschuh-Elemente (11, 12) als magnetisch anisotrope Polschuh-Elemente bereitgestellt sind.

5. Aktuatoranordnung nach Anspruch 4 mit zwei weiteren Polschuh-Elementen (13, 14), welche entlang der zweiten Richtung auf gegenüberliegenden Seiten des Aktuatorelements (1) angeordnet und jeweils eingerichtet sind, den zweiten magnetischen Fluss in der zweiten Richtung durch das Aktuatorelement (1) zu leiten.

6. Aktuatoranordnung nach Anspruch 5, wobei die zwei weiteren Polschuh-Elemente (13, 14) als magnetisch anisotrope Polschuh-Elemente bereitgestellt sind.

7. Aktuatoranordnung nach mindestens einem der vorangehenden Ansprüche, wobei das Aktuatorelement (1) als stabförmiges Aktuatorelement gebildet ist, welches entlang einer Längsrichtung (2), welche in der zweiten Richtung verläuft, eine größere Ausdehnung aufweist als in einer Querrichtung, welche in der ersten Richtung verläuft.

8. Aktuatoranordnung nach mindestens einem der vorangehenden Ansprüche, wobei die erste Flusserzeugungseinrichtung (5) und die zweite Flusserzeugungseinrichtung (6) jeweils wenigstens zwei Flusserzeugungselemente (7a, 7b, 7c, 7d, 8a, 8b, 8c, 8d, 18a, 18b) aufweisen.

9. Aktuatoranordnung nach Anspruch 8, wobei die erste Flusserzeugungseinrichtung (5) und die zweite Flusserzeugungseinrichtung (6) jeweils mit wenigstens zwei Spulen (7a, 7b, 8a, 8b) als Flusserzeugungselementen gebildet sind.

10. Aktuatoranordnung nach Anspruch 8, wobei
- die erste Flusserzeugungseinrichtung (5) mit wenigstens zwei Spulen (7a, 7b) als Flusserzeugungselementen gebildet ist, und
- die zweite Flusserzeugungseinrichtung (6) mit wenigstens zwei Permanentmagneten (18a, 18b) als Flusserzeugungselementen gebildet ist.

11. Aktuatoranordnung nach mindestens einem der Ansprüche 1 bis 7, wobei die erste Flusserzeugungseinrichtung (5) und die zweite Flusserzeugungseinrichtung (6) jeweils ein Flusserzeugungselement aufweisen, welches mit einer Spule (7a, 8a) gebildet ist, wobei die erste Flusserzeugungseinrichtung (5) eingerichtet ist, den ersten magnetischen Fluss zu erzeugen und die zweite Flusserzeugungseinrichtung (6) eingerichtet ist, den zweiten magnetischen Fluss zu erzeugen.

12. Aktuatoranordnung nach mindestens einem der vorangehenden Ansprüche mit einer der ersten Flusserzeugungseinrichtung (5) oder der zweiten Flusserzeugungseinrichtung (6) zugeordneten Vorspanneinrichtung (19), welche eingerichtet ist, als magnetische Vorspannung einen einem Betrieb der ersten Flusserzeugungseinrichtung (5), beziehungsweise der zweiten Flusserzeugungseinrichtung (6), entsprechenden magnetischen Fluss bereitzustellen, wenn die erste Flusserzeugungseinrichtung (5) und die zweite Flusserzeugungseinrichtung (6) nicht in Betrieb sind.

13. Aktuatoranordnung nach Anspruch 12, wobei eine Richtung der mittels der Vorspanneinrichtung (19) bereitgestellten magnetischen Vorspannung mittels der ersten Flusserzeugungseinrichtung (5) und/oder der zweiten Flusserzeugungseinrichtung (6) einstellbar ist.

14. Verfahren zum Betrieb einer Aktuatoranordnung, mit den Schritten:
- Bereitstellen der Aktuatoranordnung nach mindestens einem der vorangehenden Ansprüche;
- Ansteuern der ersten Flusserzeugungseinrichtung (5) und/oder der zweiten (6) Flusserzeugungseinrichtung zum Erzeugen des das Aktuatorelement (1) in der ersten Richtung durchsetzenden ersten magnetischen Flusses, derart, dass das Aktuatorelement (1) eine erste Form annimmt; und
- Ansteuern der ersten Flusserzeugungseinrichtung (5) und/oder der zweiten Flusserzeugungseinrichtung (6) zum Erzeugen des das Aktuatorelement (1) in der zweiten Richtung durchsetzenden zweiten magnetischen Flusses, derart, dass das Aktuatorelement (1) eine zweite Form annimmt, die von der ersten Form verschieden ist.

## Claims

1. Actuator assembly, comprising
- an actuator element (1), wherein the actuator element (1) comprises a magnetic shape memory alloy, and wherein a region of the actuator element (1)
- has a first length in a first direction, if the region is penetrated by a magnetic field in the first direction, and
- has a second length in the first direction, different from the first length, if the region is penetrated by a magnetic field in a second direction that is perpendicular to the first direction;
- a first flux generating device (5) for generating a magnetic flux;
- a second flux generating device (6) for generating a magnetic flux;
- a control device (15) configured to control the first flux generating device (5) and/or the second flux generating device (6) according to a first operating state and a second operating state, such that
- in the first operating state, the actuator element (1) is penetrated by a first magnetic flux in the first direction, and
- in the second operating state, the actuator element (1) is penetrated by a second magnetic flux in the second direction; and
- a pole shoe element (11, 12, 13, 14) which is configured to guide the first magnetic flux in the first direction through the actuator element (1) or is configured to guide the second magnetic flux in the second direction through the actuator element (1),
**characterized in that** the pole shoe element (11, 12, 13, 14) is provided as a magnetically anisotropic pole shoe element and by a flux guiding element (16, 17) assigned to the pole shoe element (11, 12, 13, 14), which is formed with a wedge shape and is arranged such that a magnetic resistance of the arrangement of pole shoe element (11, 12, 13, 14) and assigned flux guiding element (16, 17) in the direction of lower magnetic resistance of the pole shoe element (11, 12, 13, 14) is higher in edge regions of the arrangement of pole shoe element (11, 12, 13, 14) and assigned flux guiding element (16, 17) opposite along the direction of higher magnetic resistance of the pole shoe element (11, 12, 13, 14) than in a central region of the arrangement of pole shoe element (11, 12, 13, 14) and assigned flux guiding element (16, 17).

2. Actuator assembly according to claim 1, wherein
- the pole shoe element (11, 12, 13, 14) is formed with a laminate (22);
- the laminate (22) consists of an arrangement of a plurality of layers;
- the plurality of layers comprises first layers (23) of a first material and second layers (24) of a second material; and
- in the arrangement of a plurality of layers, first layers (23) and second layers (24) are alternately arranged one above the other,
wherein the first material has a first relative permeability, and the second material has a second relative permeability which is different from the first relative permeability.

3. Actuator assembly according to claim 1 or 2, wherein the pole shoe element (11, 12, 13, 14) is formed with a magnetically anisotropic material.

4. Actuator assembly according to at least one of the preceding claims with two pole shoe elements (11, 12) which are arranged along the first direction on opposite sides of the actuator element (1) and are each configured to guide the first magnetic flux in the first direction through the actuator element (1), wherein the two pole shoe elements (11, 12) are provided as magnetically anisotropic pole shoe elements.

5. Actuator assembly according to claim 4 with two further pole shoe elements (13, 14) which are arranged along the second direction on opposite sides of the actuator element (1) and are each configured to guide the second magnetic flux in the second direction through the actuator element (1).

6. Actuator assembly according to claim 5, wherein the two further pole shoe elements (13, 14) are provided as magnetically anisotropic pole shoe elements.

7. Actuator assembly according to at least one of the preceding claims, wherein the actuator element (1) is formed as a rod-shaped actuator element which has a greater extent along a longitudinal direction (2) which runs in the second direction than in a transverse direction which runs in the first direction.

8. Actuator assembly according to at least one of the preceding claims, wherein the first flux generating device (5) and the second flux generating device (6) each comprise at least two flux generating elements (7a, 7b, 7c, 7d, 8a, 8b, 8c, 8d, 18a, 18b).

9. Actuator assembly according to claim 8, wherein the first flux generating device (5) and the second flux generating device (6) are each formed with at least two coils (7a, 7b, 8a, 8b) as flux generating elements.

10. Actuator assembly according to claim 8, wherein
- the first flux generating device (5) is formed with at least two coils (7a, 7b) as flux generating elements, and
- the second flux generating device (6) is formed with at least two permanent magnets (18a, 18b) as flux generating elements.

11. Actuator assembly according to at least one of claims 1 to 7, wherein the first flux generating device (5) and the second flux generating device (6) each comprise a flux generating element which is formed with a coil (7a, 8a), wherein the first flux generating device (5) is configured to generate the first magnetic flux and the second flux generating device (6) is configured to generate the second magnetic flux.

12. Actuator assembly according to at least one of the preceding claims with a biasing device (19) assigned to the first flux generating device (5) or the second flux generating device (6), which is configured to provide as magnetic bias a magnetic flux corresponding to an operation of the first flux generating device (5), or the second flux generating device (6), respectively, when the first flux generating device (5) and the second flux generating device (6) are not in operation.

13. Actuator assembly according to claim 12, wherein a direction of the magnetic bias provided by means of the biasing device (19) is adjustable by means of the first flux generating device (5) and/or the second flux generating device (6).

14. Method for operating an actuator assembly, comprising the steps:
- providing the actuator assembly according to at least one of the preceding claims;
- controlling the first flux generating device (5) and/or the second flux generating device (6) for generating the first magnetic flux penetrating the actuator element (1) in the first direction, such that the actuator element (1) assumes a first shape; and
- controlling the first flux generating device (5) and/or the second flux generating device (6) for generating the second magnetic flux penetrating the actuator element (1) in the second direction, such that the actuator element (1) assumes a second shape which is different from the first shape.

## Revendications

1. Ensemble actionneur, doté
- d'un élément actionneur (1), l'élément actionneur (1) comportant un alliage magnétique à mémoire de forme et une zone de l'élément actionneur (1)
- présentant dans une première direction une première longueur, lorsque la zone est traversée dans la première direction par un champ magnétique et
- présentant dans la première direction une deuxième longueur, lorsque la zone est traversée par un champ magnétique dans la deuxième direction, laquelle est perpendiculaire à la première direction ;
- d'un premier système générateur de flux (5), destiné à générer un flux magnétique,
- d'un deuxième système générateur de flux (6), destiné à générer un flux magnétique ;
- d'un dispositif d'actionnement (15), lequel est configuré pour actionner le premier système générateur de flux (5) et / ou le deuxième système générateur de flux (6) selon un premier état opérationnel et un deuxième état opérationnel, de telle sorte que
- dans le premier état opérationnel, l'élément actionneur (1) soit traversé par un premier flux magnétique dans la première direction et
- dans le deuxième état opérationnel, l'élément actionneur (1) soit traversé par un deuxième flux magnétique dans la deuxième direction ; et
- d'un élément à pièce polaire (11, 12, 13, 14), lequel est configuré pour diriger la premier flux magnétique dans la première direction à travers l'élément actionneur (1) ou est configuré pour diriger le deuxième flux magnétique dans la deuxième direction à travers l'élément actionneur (1),
**caractérisé en ce que** l'élément à pièce polaire (11, 12, 13, 14) est mis à disposition sous la forme d'un élément à pièce polaire anisotrope et par un élément guide de flux (16, 17) associé à l'élément à pièce polaire (11, 12, 13, 14), lequel est conçu de manière cunéiforme et est placé de telle sorte que dans la direction de plus basse résistance de l'élément à pièce polaire (11, 12, 13, 14), une résistance magnétique de l'ensemble constitué de l'élément à pièce polaire (11, 12, 13, 14) et de l'élément de guidage (16, 17) associé soit plus haut dans des zones de bordure opposées de l'ensemble constitué de l'élément à pièce polaire (11, 12, 13, 14) et de l'élément de guidage (16, 17) associé, le long de la direction d'un champ magnétique plus élevé de l'élément à pièce polaire (11, 12, 13, 14) que dans une zone centrale de l'ensemble constitué de l'élément à pièce polaire (11, 12, 13, 14) et de l'élément de guidage (16, 17) associé.

2. Ensemble actionneur selon la revendication 1,
- l'élément à pièce polaire (11, 12, 13, 14) étant constitué avec un stratifié (22) ;
- le stratifié (22) étant constitué d'un ensemble de plusieurs couches ;
- les plusieurs couches comprenant des premières couches (23) dans une première matière et des deuxièmes couches (24) dans une deuxième matière ; et
- dans l'ensemble de plusieurs couches, des premières couches (23) et des deuxièmes couches (24) étant alternativement superposées,
la première matière faisant preuve d'un premier indice de perméabilité et la deuxième matière faisant preuve d'un deuxième indice de perméabilité, lequel est différent du premier indice de perméabilité.

3. Ensemble actionneur selon la revendication 1 ou 2, l'élément à pièce polaire (11, 12, 13, 14) étant constitué d'une matière anisotrope magnétique.

4. Ensemble actionneur selon au moins l'une quelconque des revendications précédentes, doté de deux éléments à pièce polaire (11, 12), lesquels sont placés le long de la première direction sur des faces opposées de l'élément actionneur (1) et dont chacun est configuré pour diriger le premier flux magnétique dans la première direction à travers l'élément actionneur (1), les deux éléments à pièce polaire (11, 12) étant mis à disposition sous la forme d'éléments à pièce polaire anisotropes magnétiques.

5. Ensemble actionneur selon la revendication 4, doté de deux éléments à pièce polaire (13, 14) supplémentaires, lesquels sont placés le long de la deuxième direction sur des faces opposées de l'élément actionneur (1) et dont chacun est configuré pour diriger le deuxième flux magnétique dans la deuxième direction à travers l'élément actionneur (1).

6. Ensemble actionneur selon la revendication 5, les deux éléments à pièce polaire (13, 14) supplémentaires étant mis à disposition sous la forme d'éléments à pièce polaire anisotropes magnétiques.

7. Ensemble actionneur selon au moins l'une quelconque des revendications précédentes, l'élément actionneur (1) étant conçu sous la forme d'un élément actionneur en forme de barre, lequel le long d'une direction longitudinale (2), laquelle s'écoule dans la deuxième direction, fait preuve d'une extension plus grande que dans la direction transversale, laquelle s'écoule dans la première direction.

8. Ensemble actionneur selon au moins l'une quelconque des revendications précédentes, le premier système générateur de flux (5) et le deuxième système générateur de flux (6) comportant chacun au moins deux éléments générateurs de flux (7a, 7b, 7c, 7d, 8a, 8b, 8c, 8d, 18a, 18b).

9. Ensemble actionneur selon la revendication 8, le premier système générateur de flux (5) et le deuxième système générateur de flux (6) étant conçus chacune avec au moins deux bobines (7a, 7b, 8a, 8b) en tant qu'éléments générateurs de flux.

10. Ensemble actionneur selon la revendication 8,
- le premier système générateur de flux (5) étant conçu avec au moins deux bobines (7a, 7b) en tant qu'éléments générateurs de flux et
- le deuxième système générateur de flux (6) étant conçu avec au moins deux aimants permanents (18a, 18b) en tant qu'éléments générateurs de flux.

11. Ensemble actionneur selon au moins l'une quelconque des revendications 1 à 7, le premier système générateur de flux (5) et le deuxième système générateur de flux (6) comportant chacun un élément générateur de flux, lequel est constitué avec une bobine (7a, 8a), le premier système générateur de flux (5) étant configuré pour générer le premier flux magnétique et le deuxième système générateur de flux (6) étant configuré pour générer le deuxième flux magnétique.

12. Ensemble actionneur selon au moins l'une quelconque des revendications précédentes, doté d'un système de tension de polarisation (19) associé au premier système générateur de flux (5) ou au deuxième système générateur de flux (6), lequel est configuré pour mettre à disposition en tant que tension de polarisation magnétique un flux magnétique correspondant à un fonctionnement du premier système générateur de flux (5), respectivement du deuxième système générateur de flux (6), lorsque le premier système générateur de flux (5) et le deuxième système générateur de flux (6) ne sont pas en fonctionnement.

13. Ensemble actionneur selon la revendication 12, une direction de la tension de polarisation magnétique mise à disposition au moyen du système de tension de polarisation (19) étant réglable au moyen du premier système générateur de flux (5) et / ou du deuxième système générateur de flux (6).

14. Procédé opérationnel d'un ensemble actionneur, comportant les étapes consistant à :
- mettre à disposition l'ensemble actionneur selon au moins l'une quelconque des revendications précédentes,
- commander le premier système générateur de flux (5) et / ou le deuxième système générateur de flux (6), pour générer le premier flux magnétique traversant l'élément actionneur (1) dans la première direction, de telle sorte que l'élément actionneur (1) adopte une première forme ; et
- commander le premier système générateur de flux (5) et / ou le deuxième système générateur de flux (6), pour générer le deuxième flux magnétique traversant l'élément actionneur (1) dans la deuxième direction, de telle sorte que l'élément actionneur (1) adopte une deuxième forme, qui est différente de la première forme.
